# EUROPEAN PATENT APPLICATION

(11) **EP 4 611 499 A1**
(43) Date of publication of application: **03.09.2025**
(21) Application number: 24210839.7
(22) Date of filing: 05.11.2024
(51) Int. Cl.: H10B 43/27, H10B 43/50

(54) **SEMICONDUCTOR DEVICES AND DATA STORAGE SYSTEMS INCLUDING THE SAME**

(30) Priority: 28.02.2024 KR 20240029035
(71) Applicant: Samsung Electronics Co., Ltd., Suwon-si, Gyeonggi-do 16677 (KR)
(72) Inventor: KIM, Hyeongjin, 16677 Suwon-si, Gyeonggi-do (KR); CHUNG, Sunghee, 16677 Suwon-si, Gyeonggi-do (KR); SHIN, Joongshik, 16677 Suwon-si, Gyeonggi-do (KR); PARK, Kyungeun, 16677 Suwon-si, Gyeonggi-do (KR); SUNG, Jeongyong, 16677 Suwon-si, Gyeonggi-do (KR); HAN, Jeehoon, 16677 Suwon-si, Gyeonggi-do (KR)
(74) Representative: Kuhnen & Wacker Patent- und Rechtsanwaltsbüro PartG mbB

(57) **Abstract**

A semiconductor device includes a plate layer (101); gate electrodes on the plate layer (101) and spaced apart from each other in a first direction (Z), and extending by different lengths in a second direction (X); interlayer insulating layers (120) alternately stacked with the gate electrodes (130); channel structures (CH) penetrating at least a portion of the gate electrodes (130); and contact plugs (170) respectively connected to the gate electrodes (130) and extending in the first direction (Z). Each of the gate electrodes (130) comprises a lower region (130_1) and an upper region (130_2) on the lower region (130_1) and exposed from the interlayer insulating layers (120), the upper region (130_2) comprises a region having a level of an upper surface thereof lowered. An outer side surface of the upper region (130_2) in the second direction (X) is spaced apart from an outer side surface of the lower region (130_1) in the second direction (X) and is on the lower region (130_1).

## Description

### BACKGROUND

Various example embodiments relate to a semiconductor device and/or a data storage system including the same.

A semiconductor device able to store high-capacity data in a data storage system requiring data storage has been necessary or desired. Accordingly, a method for increasing data storage capacity of a semiconductor device has been researched. For example, as a method for increasing data storage capacity of a semiconductor device, a semiconductor device including memory cells arranged three-dimensionally, instead of memory cells arranged two-dimensionally, has been suggested.

### SUMMARY

Various example embodiments may provide a semiconductor device having improved reliability.

Alternatively or additionally, various example embodiments may provide a data storage system including a semiconductor device having improved reliability.

According to some example embodiments, a semiconductor device includes: a first semiconductor structure comprising a substrate, circuit elements on the substrate, and circuit interconnection lines on the circuit elements; and a second semiconductor structure on the first semiconductor structure and having first and second regions. The second semiconductor structure comprises, a plate layer, gate electrodes on the plate layer, spaced apart from each other in a first direction perpendicular to an upper surface of the plate layer, extending by different lengths in a second direction perpendicular to the first direction, and respectively comprising a lower region extending from the first region and an upper region in the second region, the upper region on the lower region, interlayer insulating layers alternately stacked with the gate electrodes, channel structures penetrating at least a portion of the gate electrodes in the first region and extending in the first direction, contact plugs respectively connected to the gate electrodes in the second region and extending in the first direction, and a pad insulating layer interposed between the lower region and the upper region of each of the gate electrodes and spaced apart from the interlayer insulating layers.

Alternatively or additionally according to various example embodiments, a semiconductor device includes: a plate layer; gate electrodes on the plate layer, spaced apart from each other in a first direction, perpendicular to an upper surface of the plate layer , and extending by different lengths in a second direction perpendicular to the first direction; interlayer insulating layers alternately stacked with the gate electrodes; channel structures penetrating at least a portion of the gate electrodes and extending in the first direction; and contact plugs respectively connected to the gate electrodes and extending in the first direction. Each of the gate electrodes comprises a lower region and an upper region exposed from the interlayer insulating layers on the lower region, the upper region comprises a region having a level of an upper surface thereof be lowered, and an outer side surface of the upper region in the second direction is spaced apart from an outer side surface of the lower region in the second direction and is on the lower region.

Alternatively or additionally according to various example embodiments, a data storage system includes: a semiconductor storage device comprising a first semiconductor structure comprising circuit elements, a second semiconductor structure on the first semiconductor structure and having first and second regions, and an input/output pad electrically connected to the circuit elements; and a controller electrically connected to the semiconductor storage device through the input/output pad and configured to control the semiconductor storage device. The second semiconductor structure comprises: a plate layer; gate electrodes on the plate layer, spaced apart from each other in a first direction, perpendicular to an upper surface of the plate layer, and respectively comprising a lower region extending from the first region in a second direction perpendicular to the first direction, and an upper region on the lower region and in the second region; channel structures penetrating at least a portion of the gate electrodes in the first region and extending in the first direction; contact plugs respectively connected to the gate electrodes in the second region and extending in the first direction; and a pad insulating layer interposed between the lower region and the upper region of each of the gate electrodes.

### BRIEF DESCRIPTION OF DRAWINGS

The above and other aspects, features, and advantages of various example embodiments will be more clearly understood from the following detailed description, taken in conjunction with the accompanying drawings, in which:
FIG. 1 is a plan view illustrating a semiconductor device according to some example embodiments;
FIGS. 2A and 2B are cross-sectional views schematically illustrating a semiconductor device according to some example embodiments;
FIGS. 3A and 3B are enlarged views schematically illustrating some regions of a portion of a semiconductor device according to some example embodiments;
FIGS. 4A to 4C are enlarged views schematically illustrating a portion of a semiconductor device according to some example embodiments;
FIGS. 5 to 7 are cross-sectional views illustrating a semiconductor device according to some example embodiments;
FIGS. 8A to 8M are cross-sectional views illustrating a method of manufacturing a semiconductor device according to some example embodiments;
FIG. 9 is a flowchart illustrating a method of manufacturing a semiconductor device according to some example embodiments;
FIG. 10 is a view schematically illustrating a data storage system including a semiconductor device according to some example embodiments;
FIG. 11 is a perspective view schematically illustrating a data storage system including a semiconductor device according to some example embodiments; and
FIG. 12 is a cross-sectional view schematically illustrating a semiconductor package according to an example embodiment.

### DETAILED DESCRIPTION

Hereinafter, various example embodiments will be described with reference to the accompanying drawings.

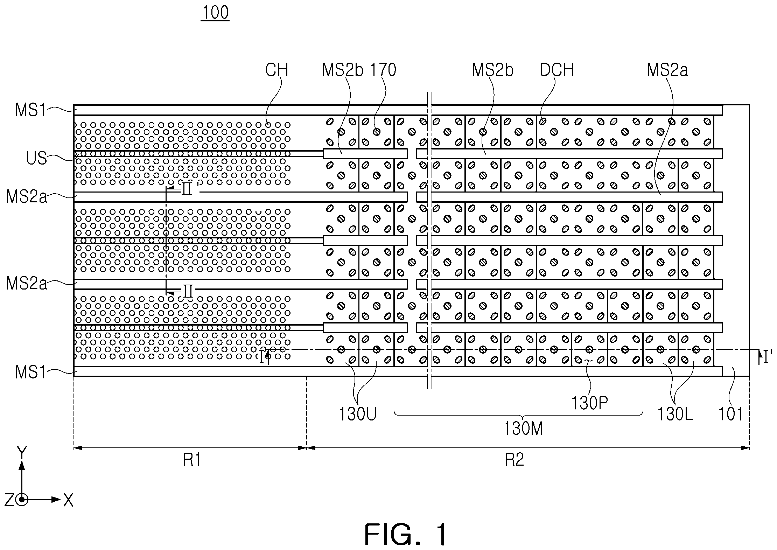

FIG. 1 is a plan view illustrating a semiconductor device according to some example embodiments.

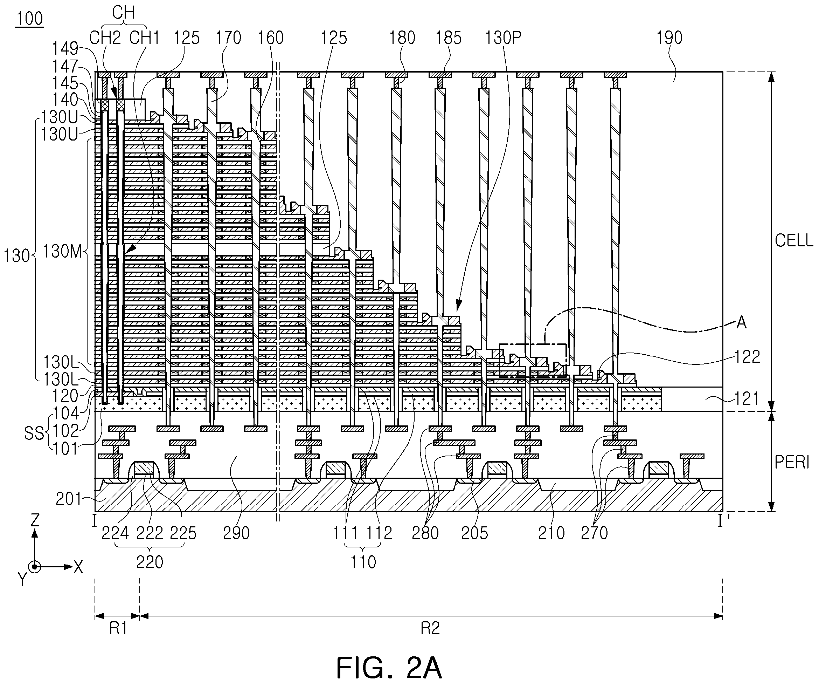

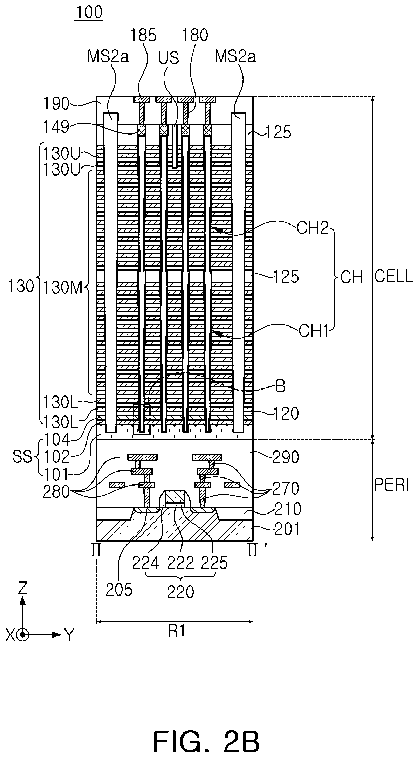

FIGS. 2A and 2B are cross-sectional views schematically illustrating a semiconductor device according to some example embodiments. FIGS. 2A and 2B illustrate cross-sectional views, taken along lines I-I' and II-II' in FIG. 1, respectively.

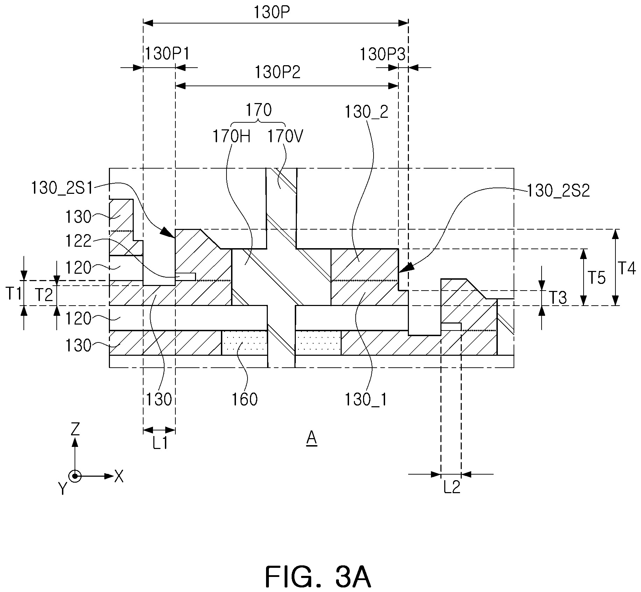

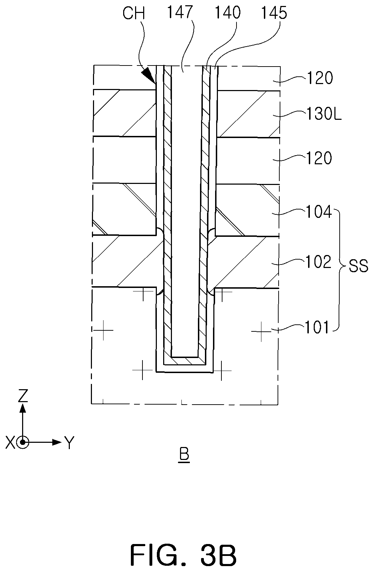

FIGS. 3A and 3B are enlarged views schematically illustrating some regions of a portion of a semiconductor device according to some example embodiments. FIG. 3A is an enlarged view illustrating region "A" in FIG. 2A, and FIG. 3B is an enlarged view illustrating region "B" in FIG. 2B.

Referring to FIGS. 1 to 3B, the semiconductor device 100 may include a peripheral circuit region PERI, a first semiconductor structure including a substrate 201, and a memory cell region CELL, a second semiconductor structure including a plate layer 101. The memory cell region CELL may be disposed on the peripheral circuit region PERI. Alternately, in some example embodiments, the memory cell region CELL may be disposed below the peripheral circuit region PERI.

The peripheral circuit region PERI may include a substrate 201, impurity regions 205 and device isolation layers 210 disposed in the substrate 201, circuit devices 220 disposed on the substrate 201, a peripheral region insulating layer 290, circuit contact plugs 270, and circuit interconnection lines 280. Although the circuit devices 220 are illustrated as extending in a Y-direction, example embodiments are not limited thereto, and in some cases the circuit devices 220 alternatively or additionally may extend in an X-direction and/or in a direction diagonal to the X direction or the Y direction.

The substrate 201 may have an upper surface extending in the X-direction and the Y-direction (which may be perpendicular to the X-direction). An active region may be defined in the substrate 201 by the device isolation layers 210. The impurity regions 205 including impurities may be disposed in a portion of the active region. The substrate 201 may include a semiconductor material, such as one or more of a group IV semiconductor, a group III-V compound semiconductor, or a group II-VI compound semiconductor. The substrate 201 may be provided as a bulk wafer and/or a chip singulated from the bulk wafer, and/or as an epitaxial layer.

The circuit devices 220 may include a planar transistor; however, example embodiments are not limited to planar transistors. Each of the circuit devices 220 may include a circuit gate dielectric layer 222, a spacer layer 224, and a circuit gate electrode 225. The impurity regions 205 may be disposed in the substrate 201 on both sides of the circuit gate electrode 225 as source/drain regions.

The peripheral region insulating layer 290 may be disposed on the circuit device 220 on the substrate 201. The peripheral region insulating layer 290 may include a plurality of insulating layers formed in different process steps. The peripheral region insulating layer 290 may be formed of (e.g., may include) an insulating material such as but not limited to an oxide.

The circuit contact plugs 270 and the circuit interconnection lines 280 may form a circuit interconnection structure electrically connected to the circuit devices 220 and the impurity regions 205. The circuit contact plugs 270 may have a cylindrical shape or a tapered cylindrical shape, and the circuit interconnection lines 280 may have or may include a component having a line shape. An electrical signal may be applied to the circuit element 220 through the circuit contact plugs 270 and circuit interconnection lines 280. In a region not shown, the circuit contact plugs 270 may also be connected to the circuit gate electrode 225. The circuit interconnection lines 280 may be connected to the circuit contact plugs 270 and may be arranged in multiple layers. The circuit contact plugs 270 and the circuit interconnection lines 280 may include a conductive material, such as one or more of tungsten (W), copper (Cu), aluminum (Al), or the like, and each component may further include a diffusion barrier. In some example embodiments, the numbers of layers of the circuit contact plugs 270 and the circuit interconnection lines 280 may be varied.

The memory cell region CELL may have first and second regions R1 and R2, and may include a source structure SS, gate electrodes 130 stacked on the source structure SS, interlayer insulating layers 120 alternately stacked with the gate electrodes 130, channel structures CH disposed to penetrate the stack structure of the gate electrodes 130 in the first region R1, first and second isolation regions MS1, MS2a, and MS2b extending by penetrating the gate electrodes 130, upper separation regions US penetrating a portion of the gate electrodes 130 disposed on an upper portion of the gate electrodes 130, pad insulating layers 122 interposed in the gate electrodes 130, and contact plugs 170 connected to the gate electrodes 130 in the second region R2 and extending vertically. The memory cell region CELL may further include a horizontal insulating layer 110 disposed below the gate electrodes 130 in the second region R2, substrate insulating layers 121 disposed to penetrate the plate layer 101, support structures DCH disposed to penetrate the stack structure of the gate electrodes 130 in the second region R2, contact insulating layers 160 around the contact plugs 170, studs 180 on the channel structures CH and the contact plugs 170, cell interconnection lines 185 on the studs 180, and a cell region insulating layer 190 covering the gate electrodes 130.

In the memory cell region CELL, the first region R1 may be or may include a region in which the gate electrodes 130 are vertically stacked and the channel structures CH are disposed, and memory cells may be disposed in the first region R1. The second region R2 may be or may include a region in which the gate electrodes 130 extend by different lengths, and may correspond to a region for electrically connecting the memory cells to the peripheral circuit region PERI. The second region R2 may be disposed on at least one end of the first region R1 in at least one direction, that is, for example, the X-direction. The semiconductor device 100 may be a cell-over-periphery (COP) device; example embodiments are not limited thereto.

The source structure SS may include a plate layer 101, a first horizontal conductive layer 102, and a second horizontal conductive layer 104 stacked in order in the first region R1. However, in some example embodiments, the number of conductive layers constituting (or included in) the source structure SS may be varied.

The plate layer 101 may have a plate shape and may function as at least a portion of a common source line of the semiconductor device 100. The plate layer 101 may have an upper surface extending in the X-direction and the Y-direction. The plate layer 101 may include a conductive material. For example, the plate layer 101 may include a semiconductor material, such as one or more of a group IV semiconductor, a group III-V compound semiconductor, or a group II-VI compound semiconductor. For example, the group IV semiconductor may include one or more of silicon, germanium or silicon-germanium. The plate layer 101 may further include impurities. The plate layer 101 may be provided as a polycrystalline semiconductor layer such as a polycrystalline silicon layer and/or as an epitaxial layer.

The first and second horizontal conductive layers 102 and 104 may be stacked in order on the upper surface of the plate layer 101 in the first region R1. The first horizontal conductive layer 102 may not extend to the second region R2, and the second horizontal conductive layer 104 may extend to the second region R2. The first horizontal conductive layer 102 may function as a portion of the common source line of the semiconductor device 100, and for example, may function as a common source line together with the plate layer 101. As illustrated in FIG. 3B, the first horizontal conductive layer 102 may be directly connected to the channel layer 140 around the channel layer 140. The second horizontal conductive layer 104 may be in contact with the plate layer 101 in a portion of regions of the second region R2 in which the first horizontal conductive layer 102 and the horizontal insulating layer 110 are not disposed. The first and second horizontal conductive layers 102 and 104 may include a semiconductor material, such as polycrystalline silicon, and in some examples may be doped or undoped.

The horizontal insulating layer 110 may be disposed on the plate layer 101 on the same level as a level of the first horizontal conductive layer 102 in at least a portion of the second region R2. The horizontal insulating layer 110 may include first and second horizontal insulating layers 111 and 112 alternately stacked on the second region R2 of the plate layer 101. The horizontal insulating layer 110 may be layers remaining after a portion of the first horizontal conductive layer 102 is replaced with the first horizontal conductive layer 102 in the process of manufacturing the semiconductor device 100.

The horizontal insulating layer 110 may include one or more of silicon oxide, silicon nitride, silicon carbide, or silicon oxynitride. The first horizontal insulating layers 111 and the second horizontal insulating layer 112 may include different insulating materials. For example, the first horizontal insulating layers 111 may be formed of the same material as that of the interlayer insulating layers 120, and the second horizontal insulating layer 112 may be formed of a material different from that of the interlayer insulating layers 120.

The substrate insulating layers 121 may be disposed to penetrate the plate layer 101, the horizontal insulating layer 110 and the second horizontal conductive layer 104 in a portion of the second region R2. The substrate insulating layers 121 may be further disposed in the first region R1, for example, may be disposed in a region in which a through-via (e.g., a through-silicon via or TSV) extending to from the memory cell region CELL to the peripheral region PERI is disposed. An upper surface of the substrate insulating layer 121 may be coplanar with an upper surface of the second horizontal conductive layer 104, but the present inventive concept is not limited thereto. The substrate insulating layer 121 may include an insulating material, such as one or more of silicon oxide, silicon nitride, silicon carbide, or silicon oxynitride.

The gate electrodes 130 may be vertically stacked and spaced apart from each other on the plate layer 101 to form a stack structure together with the interlayer insulating layers 120. The stack structure may include vertically stacked lower and upper stack structures. However, in some example embodiments, the stack structure may be configured as a single stack structure.

The gate electrodes 130 may include lower gate electrodes 130L constituting a gate of a ground select transistor, memory gate electrodes 130M constituting a plurality of memory cells, and upper gate electrodes 130U constituting gates of string select transistors. The number of memory gate electrodes 130M constituting or included in the memory cells may be determined depending on a capacity of the semiconductor device 100. In some example embodiments, the numbers of the upper and lower gate electrodes 130U and 130L each may be 1 to 4 or more, and may have a structure the same as or different from the memory gate electrodes 130M. In some example embodiments, the gate electrodes 130 may further include a gate electrode 130 disposed above the upper gate electrodes 130U and/or below the lower gate electrodes 130L of the upper gate electrodes 130U and constituting an erase transistor used for an erase operation using a gate induced drain leakage (GIDL) phenomenon. A portion of the gate electrodes 130, for example, the memory gate electrodes 130M adjacent to the upper or lower gate electrodes 130U and 130L, may be dummy gate electrodes (e.g., gate electrodes that are not electrically active during operation of the semiconductor device 100).

As illustrated in FIG. 1, the gate electrodes 130 may be isolated from each other in the Y-direction by the first isolation regions MS 1 continuously extending in the first region R1 and the second region R2. The gate electrodes 130 between a pair of the first isolation regions MS1 may form a single memory block, but the range of the memory block is not limited thereto. A portion of the gate electrodes 130, for example, the memory gate electrodes 130M, may form a layer in a memory block.

The gate electrodes 130 may be vertically stacked and spaced apart from each other on the first region R1 and the second region R2, may extend by different lengths from the first region R1 to the second region R2 and may form a stepped structure in the form of a staircase in a portion of the second region R2. The gate electrodes 130 may be disposed to have a stepped structure in the Y-direction as well. Due to the stepped structure, in the gate electrodes 130, the lower gate electrode 130 may extend longer than the gate electrode 130 disposed thereabove, such that the gate electrodes 130 may have regions in which uppers surfaces may be exposed upwardly from the interlayer insulating layers 120 and the other gate electrodes 130, and the regions may be referred to as pad regions 130P. In each gate electrode 130, the pad region 130P may be a region including end portions of the gate electrodes 130 in the X-direction. The gate electrodes 130 may be connected to the contact plugs 170 in the pad regions 130P, respectively. The gate electrodes 130 may include regions with increased thicknesses in the pad regions 130P.

As shown in FIG. 3A, the gate electrode 130 may include a lower region 130_1 extending from the first region R1 and an upper region 130_2 disposed on the lower region 130_1 in the pad region 130P. The pad region 130P may include first to third pad regions 130P1, 130P2 and 130P3 arranged in order from the first region R1 in the X-direction. The upper region 130_2 may be disposed in the second pad region 130P2, and an upper surface of the lower region 130_1 may be exposed from the upper region 130_2 in the first pad region 130P1 and the third pad region 130P3.

The lower region 130_1 may extend to a first thickness T1 in the entire first region R1 and a portion of the second region R2. The lower region 130_1 may have a first thickness T1 in a region in which at least the upper surface thereof is covered with the interlayer insulating layer 120. In the first pad region 130P1, the lower region 130_1 may have a second thickness T2 that is less than the first thickness T1. The first pad region 130P1 may be a region between a side surface of the interlayer insulating layer 120 and the upper region 130_2. In the third pad region 130P3, the lower region 130_1 may have a third thickness T3 that is less than the first thickness T1. The third thickness T3 may be less than or equal to the second thickness T2.

The upper region 130_2 may be disposed on the lower region 130_1 and the pad insulating layer 122 in the second pad region 130P2. The upper region 130_2 may have a first side surface 130_2S1 and a second side surface 130_2S2 opposite to each other in the X-direction. The first side surface 130_2S1 may be referred to as an inner side surface, and the second side surface 130_2S2 may be referred to as an outer side surface.

The upper region 130_2 may include first to third portions sequentially positioned from the first side surface 130_2S1 in the X-direction. The first portion may be adjacent to the first pad region 130P1 and may have an upper surface located at a first level. The first portion may include a region that vertically overlaps the pad insulating layer 122. The second portion may include a bent region and/or a stepped region so that the overall thickness of the gate electrode 130 is reduced. The third portion may have an upper surface located at a second level lower than (or below) the first level. The first portion may be an end region including the first side surface 130_2S1, and the third portion may be an end region including the second side surface 130_2S2. The second portion may be a region in which an upper surface thereof is lowered from the first level to the second level. A degree of roundness and/or an inclination of the bent region in the second portion may depend on different embodiments. The first level may be higher than a level of a lower surface of the gate electrode 130 thereabove. The first level may be a level between the lower and upper surfaces of the upper gate electrode 130 thereabove. The first level may be higher than a level of an upper surface of the third pad region 130P3 of the gate electrode 130 thereabove, but example embodiments are not limited thereto. However, in some example embodiments, the first level may be equal to or lower than the level of the lower surface of the gate electrode 130 thereabove.

The gate electrode 130 may have a fourth thickness T4, which is (or corresponds to) the maximum thickness in the first portion. The fourth thickness T4 may be a thickness including a thickness of the pad insulating layer 122 inserted therein. The gate electrode 130 may have a fifth thickness T5 that is less than the fourth thickness T4 in the third portion. A difference between the first level and the second level, for example, a difference between the fourth thickness T4 and the fifth thickness T5, may range from about 3 nm to about 7 nm. The difference may be greater than the sum of the difference between the first thickness T1 and the second thickness T2 and the thickness of the pad insulating layer 122, but the present inventive concept is not limited thereto. When the third thickness T3 is less than the second thickness T2, the gate electrode 130 may have a minimum thickness at an outer end region of the lower region 130_1 adjacent to the second side surface 130_2S2 of the upper region 130_2. When the second thickness T2 and the third thickness T3 are the same, the gate electrode 130 may have a minimum thickness at each region of the lower region 130_1 adjacent to the first side surface 130_2S1 and the second side surface 130_2S2.

The first side surface 130_2S1 may be spaced apart from the interlayer insulating layer 120 on the gate electrode 130 by a first length L1. The first length L1 may be a length of the first pad region 130P1. The first length L1 may range from about 10 nm to about 50 nm, for example. The second side surface 130_2S2 may be spaced inward from an outer side surface of the lower region 130_1 toward the first region R1 and be positioned on the lower region 130_1. The upper surface of the lower region 130_1 may be partially exposed outside the second side surface 130_2S2, and a bent structure may be formed between the second side surface 130_2S2 and a portion of a middle side surface of the lower region 130_1 extending from the second side surface 130_2S2, and the exposed upper surface of the lower region 130_1. As used herein, unless otherwise specified, 'inner' may mean one side facing the first region R1, and 'outer' may mean one side facing away from the first region R1, `inner side surface' and `outer side surface' may also be interpreted in the same way.

The gate electrodes 130 may include a metal material, such as tungsten (W). Alternatively or additionally in some example embodiments, the gate electrodes 130 may include polycrystalline silicon such as doped polysilicon and/or a metal silicide material. Alternatively or additionally in some example embodiments, the gate electrodes 130 may further include a diffusion barrier, and for example, the diffusion barrier may include tungsten nitride (WN), tantalum nitride (TaN), titanium nitride (TiN), or a combination thereof.

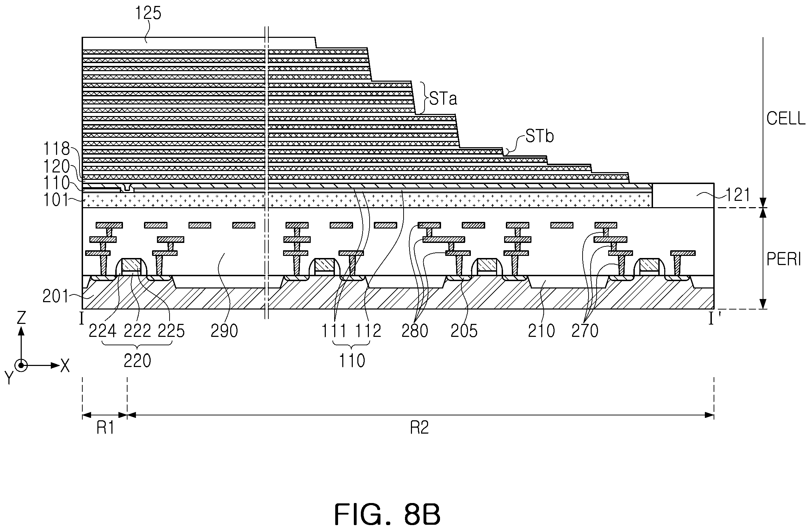

Pad insulating layers 122 may be interposed within the gate electrodes 130 in the pad regions 130P. As shown in FIG. 3A, the pad insulating layer 122 may be disposed between the lower region 130_1 and the upper region 130_2 in the second pad region 130P2. The pad insulating layer 122 may be a portion of the interlayer insulating layer 120 remaining in the gate electrode 130 according to a manufacturing process for stable isolation between adjacent pad regions 130P. This will be described in more detail below with reference to FIGS. 8B to 8L.

The pad insulating layer 122 may be disposed in the first end region of the upper region 130_2, and at least one side surface thereof may be exposed through the first side surface 130_2S1. A side surface in the X-direction of the pad insulating layer 122 exposed through the first side surface 130_2S1 may be coplanar with the first side surface 130_2S1. An upper surface, a lower surface, and at least one side surface of the pad insulating layer 122 may be covered with the gate electrode 130.

The lower surface of the pad insulating layer 122 may be positioned on substantially the same level as the lower surface of the interlayer insulating layer 120 adjacent in the X-direction. A thickness of the pad insulating layer 122 may be less than a thickness of the interlayer insulating layer 120. A second length L2 of the pad insulating layer 122 may be less than the first length L1 of the first pad region 130P1, but example embodiments are not limited thereto. The pad insulating layer 122 may include an insulating material and may include the same material as the interlayer insulating layer 120.

The interlayer insulating layers 120 may be disposed between the gate electrodes 130 to form a stack structure with the gate electrodes 130. Similarly to the gate electrodes 130, the interlayer insulating layers 120 may be spaced apart from each other in a direction perpendicular to the upper surface of the plate layer 101 and may extend in the X-direction. In the stack structure, relatively thick upper interlayer insulating layers 125 may be disposed on an uppermost portion of lower and upper stack structures. However, thicknesses and/or shapes of the interlayer insulating layers 120 and the upper interlayer insulating layer 125 may depend on different embodiments. The interlayer insulating layers 120 and the upper interlayer insulating layer 125 may include an insulating material such as silicon oxide and/or silicon nitride.

Each of the channel structures CH may form a memory cell string, and may be spaced apart from each other while forming rows and columns on the plate layer 101 in the first region R1. The channel structures CH may be disposed to form a grid pattern or may be disposed in a zigzag pattern in one direction on an X-Y plane. The channel structures CH may have a columnar shape or tapered columnar shape, and may have inclined side surfaces of which a width may decrease toward the plate layer 101 depending on an aspect ratio. In some example embodiments, at least a portion of the channel structures CH disposed on an end portion of the first region R1 may be dummy channels.

The channel structures CH may include vertically stacked first and second channel structures CH1 and CH2. The channel structures CH may have a form in which the lower first channel structures CH1 and the upper second channel structures CH2 are connected to each other, and may have a bent portion due to a difference in width in a connection region. However, in some example embodiments, the number of channel structures stacked in a Z-direction may be varied.

Each of the channel structures CH may include a channel layer 140, a gate dielectric layer 145, a channel filling insulating layer 147, and a channel pad 149 disposed in the channel hole. As illustrated in FIG. 3B, the channel layer 140 may be formed in an annular shape surrounding the channel filling insulating layer 147 therein, but in some example embodiments, the channel layer 140 may have a columnar shape such as a cylindrical shape or a prism shape without the channel filling insulating layer 147. The channel layer 140 may be connected to the first horizontal conductive layer 102 in a lower portion. The channel layer 140 may include a semiconductor material such as polycrystalline silicon and/or single crystal silicon, and may be doped or undoped.

The gate dielectric layer 145 may be disposed between the gate electrodes 130 and the channel layer 140. Although not specifically illustrated, the gate dielectric layer 145 may include a tunneling layer, a charge storage layer, and a blocking layer stacked in order from the channel layer 140. The tunneling layer may tunnel electric charges into the charge storage layer, and may include, for example, silicon oxide (SiO₂), silicon nitride (Si₃N₄), silicon oxynitride (SiON), or a combination thereof. The charge storage layer may be a charge trap layer or a floating gate conductive layer. The blocking layer may include silicon oxide (SiO₂), silicon nitride (Si₃N₄)), silicon oxynitride (SiON), a high-k dielectric material having a dielectric constant greater than that of silicon oxide, or a combination thereof. In some example embodiments, at least a portion of the gate dielectric layer 145 may extend in a horizontal direction along the gate electrodes 130.

The channel pad 149 may be disposed only on an upper end of the upper second channel structure CH2. The channel pad 149 may include, for example, doped polycrystalline silicon. The channel layer 140, the gate dielectric layer 145, and the channel filling insulating layer 147 may be connected to each other between the first channel structure CH1 and the second channel structure CH2.

The support structures DCH may be disposed to be spaced apart from each other while forming rows and columns on the plate layer 101 in the second region R2. As illustrated in FIG. 1, the support structures DCH may be disposed to surround the contact plugs 170 in four directions, respectively. However, in some example embodiments, the arrangement of the support structures DCH may be varied. The support structures DCH may have a columnar shape, and may have inclined side surfaces of which a width may decrease toward the plate layer 101 depending on an aspect ratio.

The support structures DCH may have a circular shape, an elliptical shape, or a shape similar thereto on the X-Y plane. A diameter or a maximum width of the support structures DCH may be greater than that of the channel structures CH, but example embodiments are not limited thereto. The support structures DCH may have an internal structure the same as or different from the channel structures CH. For example, the support structures DCH may not include a conductive layer and may include an insulating material such as one or more of silicon oxide, silicon nitride, or silicon oxynitride.

The first and second isolation regions MS1, MS2a, and MS2b may be disposed to penetrate the gate electrodes 130 and to extend in the X-direction. The first and second isolation regions MS1, MS2a, and MS2b may be disposed parallel to each other. The first and second isolation regions MS1, MS2a, and MS2b may penetrate the entire gate electrodes 130 stacked on the plate layer 101, may further penetrate the first and second horizontal conductive layers 102 and 104 and the horizontal insulating layer 110 therebelow, and may be connected to the plate layer 101. The first isolation regions MS1 may continuously extend in the X-direction, and the second isolation regions MS2a, and MS2b may intermittently extend between the pair of first isolation regions MS1 or may be disposed only in a portion of regions. For example, the second central isolation regions MS2a may continuously extend in the first region R1 and may intermittently extend in the X-direction in the second region R2. The second auxiliary isolation regions MS2b may be disposed only in the second region R2 and may intermittently extend in the X-direction. However, in some example embodiments, the arrangement order of the first and second isolation regions MS1, MS2a, and MS2b and the number of the first and second isolation regions MS1, MS2a, and MS2b are not limited to the example illustrated in FIG. 1.

The first and second isolation regions MS1, MS2a, and MS2b may have a shape in which a width may decrease toward the plate layer 101 due to a high aspect ratio, but example embodiments are not limited thereto, and may have side surfaces perpendicular to the upper surface of the plate layer 101. The first and second isolation regions MS1, MS2a, and MS2b may include an insulating material, such as one or more of silicon oxide, silicon nitride, or silicon oxynitride.

As illustrated in FIG. 1, the upper isolation regions US may extend in the X-direction between the first isolation regions MS1 and the second central isolation region MS2a and between the second central isolation regions MS2a in the first region R1. The upper isolation regions US may be disposed in a portion of the second region R2 and in the first region R1 to penetrate a portion of the gate electrodes 130 including the uppermost upper gate electrode 130U among the gate electrodes 130. As illustrated in FIG. 2B, the upper isolation regions US may isolate, for example, three gate electrodes 130 from each other in the Y-direction. However, the number of gate electrodes 130 isolated by the upper isolation regions US may be varied in some example embodiments. The upper isolation regions US may include an insulating material, such as one or more of silicon oxide, silicon nitride, or silicon oxynitride.

The contact plugs 170 may be connected to the contact regions 130P of the gate electrodes 130 in the second region R2. The contact plugs 170 may penetrate at least a portion of the cell region insulating layer 190 and may be connected to the contact regions 130P of the gate electrodes 130 exposed upwardly, respectively. The contact plugs 170 may penetrate the gate electrodes 130 below the contact regions 130P, penetrate the second horizontal conductive layer 104, the horizontal insulating layer 110 and the plate layer 101, and be connected to the circuit interconnection lines 280 in the peripheral circuit region PERI. The contact plugs 170 may be spaced apart from the gate electrodes 130 disposed below the contact regions 130P by the contact insulating layers 160. The contact plugs 170 may be spaced apart from the plate layer 101, the horizontal insulating layer 110 and the second horizontal conductive layer 104 by the substrate insulating layers 121. However, in some example embodiments, the contact plugs 170 may be connected to the contact regions 130P without penetrating the gate electrodes 130.

As shown in FIG. 3A, each of the contact plugs 170 may have a shape that extends horizontally in the contact region 130P. The contact plug 170 may include a vertical extension 170V extending in the Z-direction and a horizontal extension 170H extending horizontally from the vertical extension 170V and contacting the gate electrode 130. The horizontal extension 170H is disposed around the vertical extension 170V, and its entire side surface may be surrounded by the gate electrode 130. The horizontal extension 170H may be disposed within the second pad region 130P2, but example embodiments are not limited thereto. A length from a side surface of the vertical extension 170V to an end portion of the horizontal extension 170H may be less than a length from the side surface of the vertical extension 170V to outer side surfaces of the contact insulating layers 160. The contact plugs 170 may be spaced apart from the gate electrodes 130 below the contact regions 130P, that is, the gate electrodes 130 that are not electrically connected, by the contact insulating layers 160.

The contact plugs 170 may include a conductive material, such as at least one of tungsten (W), copper (Cu), aluminum (Al), or an alloy thereof. In some example embodiments, the contact plugs 170 may include a barrier layer extending along side surfaces and bottom surfaces thereof, or may have an air gap therein.

The contact insulating layers 160 may be disposed to surround the side surfaces of the respective contact plugs 170 below the contact regions 130P. The contact insulating layers 160 may be disposed to be spaced apart from each other in the Z-direction around each of the contact plugs 170. The contact insulating layers 160 may be disposed at substantially the same level as the gate electrodes 130. The contact insulating layers 160 may include an insulating material, for example, one or more of silicon oxide, silicon nitride, or silicon oxynitride.

The studs 180 and the cell interconnection lines 185 may form a cell wiring structure electrically connected to memory cells in the memory cell region CELL. The studs 180 may be connected to the channel structures CH and the contact plugs 170, and the channel structures CH and the gate electrodes 130 may be electrically connected to the cell interconnection lines 185. The studs 180 may have a plug shape, and the cell interconnection lines 185 may have a line shape. In some example embodiments, the number of plugs and interconnection lines constituting the cell wiring structure may vary. The studs 180 and the cell interconnection lines 185 may include a metal, such as one or more of tungsten (W), copper (Cu), aluminum (Al), or the like.

The cell region insulating layer 190 may be disposed to cover the stack structure of the gate electrodes 130, the contact plugs 170 or the like. The cell region insulating layer 190 may be formed of an insulating material, or may include a plurality of insulating layers.

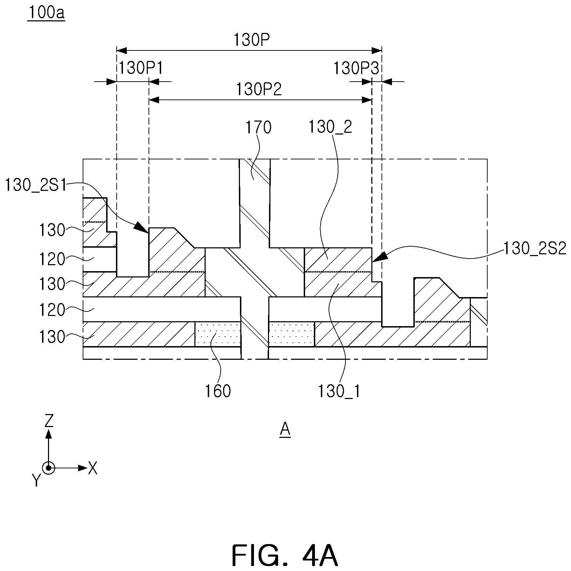

FIGS. 4A to 4C are enlarged views illustrating a portion of a semiconductor device according to various example embodiments, illustrating regions corresponding to FIG. 3A, respectively.

Referring to FIG. 4A, the semiconductor device 100a may not include the pad insulating layer 122 (see FIG. 3A). Accordingly, in the gate electrode 130, the entire lower surface of the upper region 130_2 may contact the upper surface of the lower region 130_1. In this case as well, the upper region 130_2 may have a shape in which the level of the upper surface is lowered as the upper surface is bent.

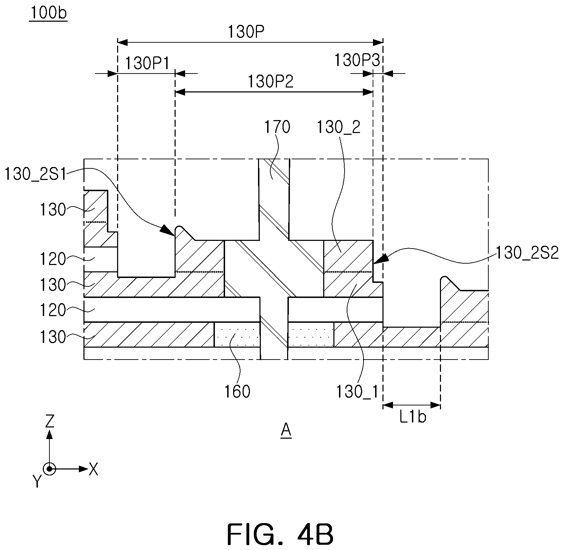

Referring to FIG. 4B, the semiconductor device 100b may not include the pad insulating layer 122 (see FIG. 3A), and the upper region 130_2 of the gate electrode 130 may not include the first portion described above with reference to FIG. 3A. The upper region 130_2 may not have a flat upper surface extending from a top end of the first side surface 130_2S1. The upper region 130_2 may have a shape in which a bent region starts from the top end of the first side surface 130_2S1 and a level of the upper surface thereof is lowered. The shape of the upper region 130_2 may be formed when a first length L1b of the first pad region 130P1 is relatively large.

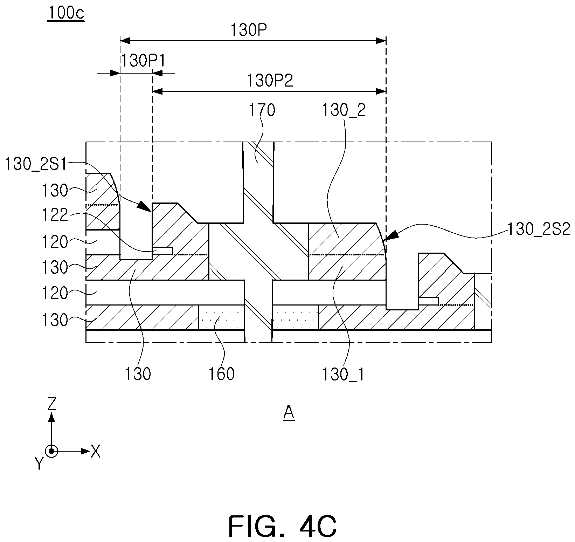

Referring to FIG. 4C, in the semiconductor device 100c, the pad region 130P may not include the third pad region 130P3 (see FIG. 3A), and the second side surface 130_2S2 of the upper region 130_2 may have a shape connected to the side surface of the lower region 130_1. The upper surface of the lower region 130_1 may not be exposed outside the upper region 130_2. The second side surface 130_2S2 may have a rounded shape, but example embodiments are not limited thereto. In some example embodiments, the second side surface 130_2S2 may extend vertically in the Z-direction.

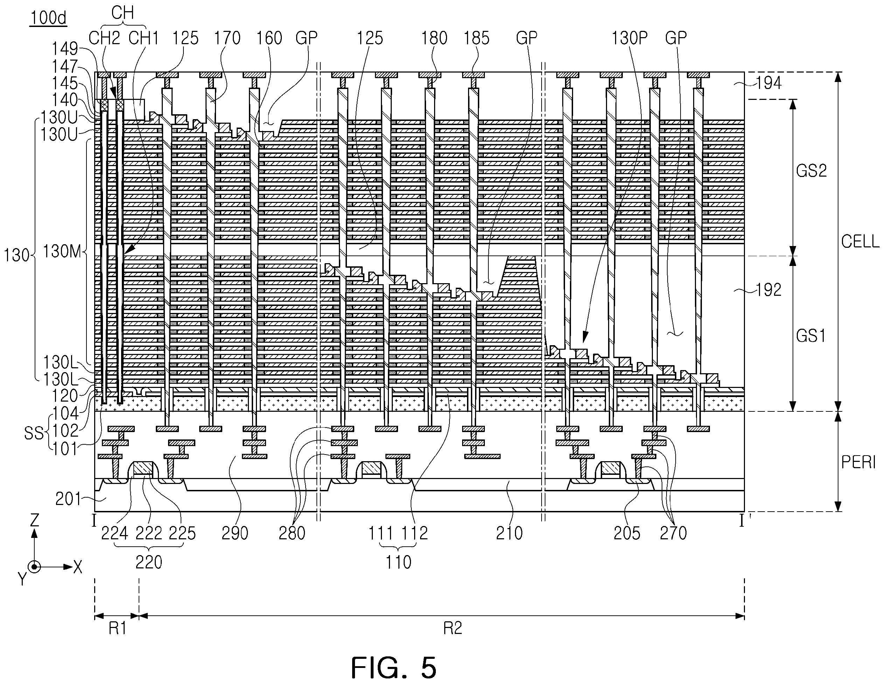

FIGS. 5 to 7 are schematic cross-sectional views illustrating a semiconductor device according to various example embodiments. Each of FIGS. 5 to 7 illustrates a cross-sectional view corresponding to FIG. 2A.

Referring to FIG. 5, in the semiconductor device 100d, a stacked form of the gate electrodes 130 in the second region R2 may be different from that in the embodiment of FIG. 2A. Additionally, the memory cell region CELL may include first and second cell region insulating layers 192 and 194.

The gate electrodes 130 may form stepped structures in a plurality of stepped regions GP. The gate electrodes 130 may have a shape in which the gate electrodes 130 are removed from an upper portion of any one of lower and upper stack structures GS1 and GS2 of the gate electrodes 130 in the stepped regions GP in a depth such as a dynamically determined (or, alternatively, predetermined) depth. The stepped regions GP may be disposed so as not to overlap each other in the Z-direction. On the stepped region GP of the lower stack structure GS1, at least a portion of the gate electrodes 130 forming the upper stack structures GS2 may extend horizontally. The stepped regions GP may be disposed in the order of the upper stack structure GS2, the lower stack structure GS1, and the upper stack structure GS2 from the first region R1 in the X-direction. However, in embodiments, the disposed form, the disposed order and the depth of the stepped regions GP may be changed in various manners. In some embodiments, the gate electrodes 130 of the upper stack structure GS2 may not be disposed on the stepped regions GP of the lower stack structure GS1.

The gate electrodes 130 may form first and second stepped structures in the respective stepped regions GP in an asymmetric form in the X-direction. The first stepped structure may be a stepped structure positioned relatively adjacent to the first region R1 and having a level decreasing in the X-direction, and the second stepped structure may be a stepped structure or an inclined structure positioned relatively away from the first region R1 and having a level increasing in the X-direction. For example, in each of the stepped regions GP, a slope of the first stepped structure may be less than a slope of the second stepped structure in the first region R1. However, in some example embodiments, the first and second stepped structures may have symmetrical shapes. In the first stepped structure, the gate electrodes 130 may be connected to the contact plugs 170, while in the second stepped structure, the gate electrodes 130 may not be connected to the contact plugs 170, thereby forming a dummy region or a dummy structure. In some example embodiments, a specific shape of the stepped structure, a number of the gate electrodes 130 forming each stepped structure, etc. are not limited to those shown in FIG. 5. In some example embodiments, the gate electrodes 130 may be disposed to have a stepped structure in the Y-direction.

The first and second cell region insulating layers 192 and 194 may be disposed to cover the lower and upper stack structures GS1 and GS2, respectively. The first and second cell region insulating layers 192 and 194 may include an insulating material.

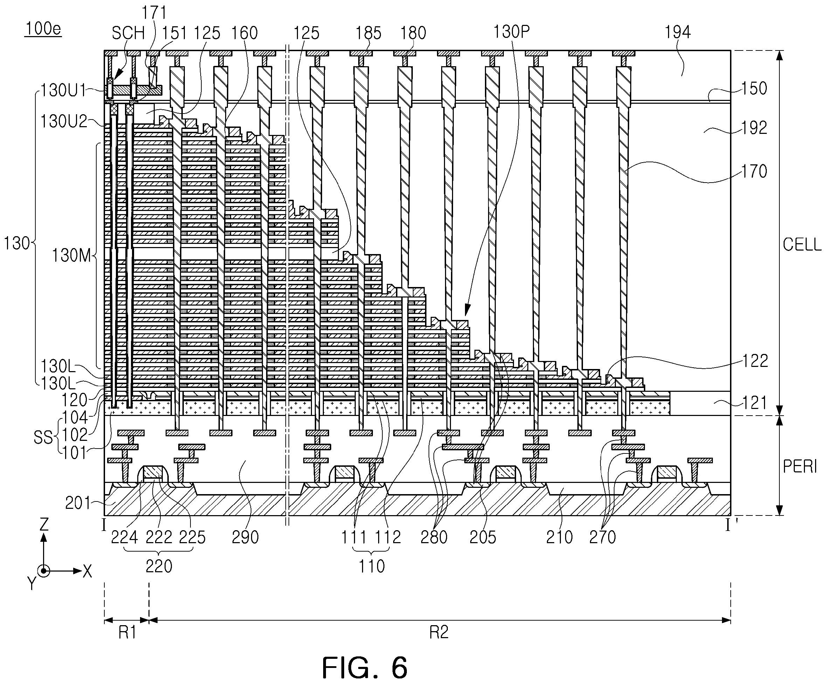

Referring to FIG. 6, the memory cell region CELL of the semiconductor device 100e may further include string channel structures SCH connected to the channel structures CH, a horizontal insulating layer 150, and an upper contact plug 171. The memory cell region CELL may further include first and second cell region insulating layers 192 and 194.

The gate electrodes 130 may include first and second upper gate electrodes 130U1 and 130U2 as the upper gate electrodes. An uppermost first upper gate electrode 130U1 may be disposed to be relatively thick compared to the other gate electrodes 130. The string channel structures SCH may be disposed to penetrate the first upper gate electrode 130U1, and the channel structures CH may be disposed to penetrate the gate electrodes 130 excluding the first upper gate electrode 130U1.

The string channel structures SCH may be respectively connected to the channel structures CH. The string channel structures SCH may be respectively disposed on the channel structures CH, and may be shifted from the channel structures CH in a horizontal direction, but example embodiments are not limited thereto. Each of the string channel structures SCH may include a string channel layer disposed in a string channel hole, and may have the same as or similar structure to the channel structures CH. The string channel layer may be connected to a connection pad 151 at a bottom end thereof, and may be electrically connected to the channel layer 140 of the channel structure CH through the connection pad 151. The connection pad 151 may include a conductive material, for example, polycrystalline silicon.

The horizontal insulating layer 150 may be disposed between the channel structures CH and the string channel structures SCH, and may extend horizontally. The horizontal insulating layer 150 may be disposed between the first upper gate electrode 130U1 and the second upper gate electrodes 130U2. The horizontal insulating layer 150 may be used as an etch stop layer when forming the string channel structures SCH, and may also be a layer used when forming the connection pads 151. The horizontal insulating layer 150 may include an insulating material, and may include a material different from those of the interlayer insulating layers 120 and the first cell region insulating layer 192. In various example embodiments, the contact plugs 170 may have a bent portion whose width is reduced on or below a lower surface of the horizontal insulating layer 150.

The upper contact plug 171 may be connected to the first upper gate electrode 130U1. The upper contact plug 171 may be connected to an upper surface or upper region of the first upper gate electrode 130U1 without penetrating the first upper gate electrode 130U1.

The first and second cell region insulating layers 192 and 194 may be disposed above and below the horizontal insulating layer 150, respectively. The first and second cell region insulating layers 192 and 194 may include an insulating material.

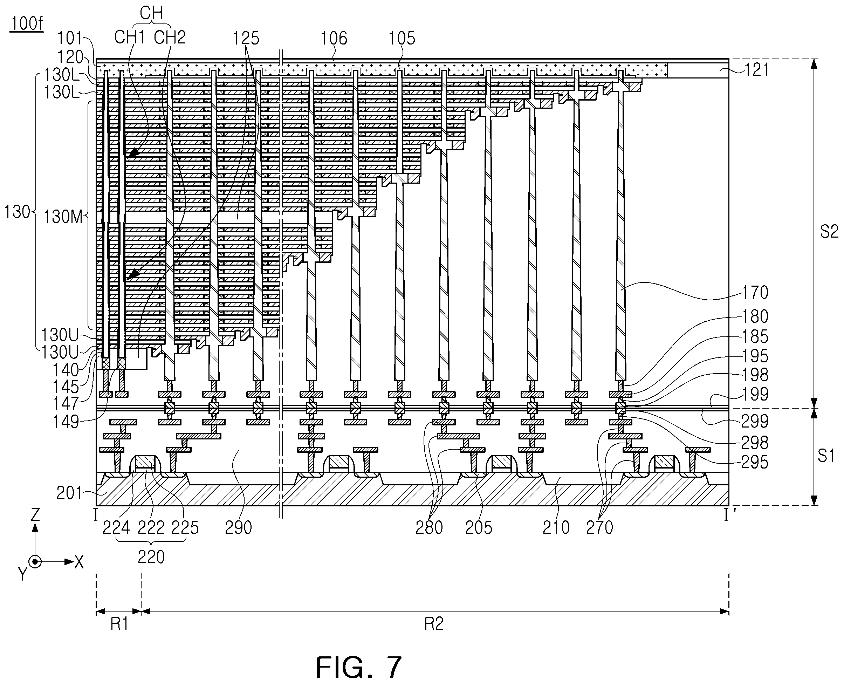

Referring to FIG. 7, the semiconductor device 100f may include a first semiconductor structure S1 and a second semiconductor structure S2 bonded using a wafer bonding method.

The description of the peripheral circuit region PERI described above with reference to FIGS. 1 to 2B may be applied to the first semiconductor structure S1. However, the first semiconductor structure S1 may further include first bonding vias 295, first bonding metal layers 298, and first bonding insulating layer 299, which are bonding structures. The first bonding vias 295 may be disposed above the uppermost circuit interconnection lines 280 and connected to the circuit interconnection lines 280. At least a portion of the first bonding metal layers 298 may be connected to the first bonding vias 295 on the first bonding vias 295. The first bonding metal layers 298 may be connected to the second bonding metal layers 198 of the second semiconductor structure S2. The bonding metal layers 298, together with the second bonding metal layers 198, may provide an electrical connection path according to bonding of the first semiconductor structure S1 and the second semiconductor structure S2. A portion of the first bonding metal layers 298 may not be connected to the lower circuit interconnection lines 280, and may be disposed only for bonding. The first bonding vias 295 and the first bonding metal layers 298 may include a conductive material, for example, copper (Cu). The first bonding insulating layer 299 may be disposed around the first bonding metal layers 298. The first bonding insulating layer 299 may also function as a diffusion prevention layer or diffusion mitigation layer of the first bonding metal layers 298, and may include, for example, at least one of SiN, SiON, SiCN, SiOC, SiOCN and SiO.

The description of the memory cell region CELL described above with reference to FIGS. 1 to 3B may be applied to the second semiconductor structure S2, unless otherwise specified. The second semiconductor structure S2 may further include second bonding vias 195, second bonding metal layers 198, and second bonding insulating layers 199, which are bonding structures. The second semiconductor structure S2 may further include a passivation layer 106 covering an upper surface of a plate layer 101 and a cover insulating layer 105 disposed between the contact plugs 170 and the plate layer 101.

The second bonding vias 195 and the second bonding metal layers 198 may be disposed below lowermost cell interconnection lines 185. The second bonding vias 195 may connect the cell interconnection lines 185 and the second bonding metal layers 198, and the second bonding metal layers 198 may be bonded to the first bonding metal layers 298 of the first semiconductor structure S1. The second bonding insulating layer 199 may be bonded and connected to the first bonding insulating layer 299 of the first semiconductor structure S1. The second bonding vias 195 and the second bonding metal layers 198 may include a conductive material, for example, copper (Cu). The second bonding insulating layer 199 may include, for example, at least one of SiO, SiN, SiCN, SiOC, SiON and SiOCN.

The first and second semiconductor structures S1 and S2 may be bonded by bonding of the first bonding metal layers 298 and the second bonding metal layers 198 and bonding of the first bonding insulating layer 299 and the second bonding insulating layer 199. The bonding of the first bonding metal layers 298 and the second bonding metal layers 198 may be or may include, for example, copper-to-copper (Cu-Cu) bonding, and the bonding of the first bonding insulating layer 299 and the insulating layer 199 may be or may include, for example, dielectric-to-dielectric bonding, such as SiCN-SiCN bonding. The first and second semiconductor structures S1 and S2 may be bonded by hybrid bonding including copper-to-copper (Cu-Cu) bonding and dielectric-to-dielectric bonding.

In this embodiment, the second semiconductor structure S2 may not include the first and second horizontal conductive layers 102 and 104 (see FIG. 2A). The channel structures CH may be directly connected to the plate layer 101 with channel layers 140 exposed through upper ends thereof. However, an electrical connection form of the channel structures CH and a common source line may be changed in various embodiments, and it may be also possible that the channel structures CH and a source structure SS may have the same structure as the embodiment of FIG. 2A.

The passivation layer 106 may be disposed on the upper surface of the plate layer 101 and may protect the semiconductor device 100f. The cover insulating layer 105 may be disposed between the contact plugs 170 and the plate layer 101. The cover insulating layer 105 may cover upper ends of the contact plugs 170, and may extend along the lower surface of the plate layer 101. However, in some example embodiments, the cover insulating layer 105 may be disposed in various manners of electrically separating the contact plugs 170 from the plate layer 101. In some embodiments, the cover insulating layer 105 may be disposed in the same form as the substrate insulating layer 121 around the contact plugs 170. The passivation layer 106 and the cover insulating layer 105 may include an insulating material, for example, at least one of silicon oxide, silicon nitride, and silicon carbide, and may be composed of a plurality of insulating layers according to embodiments.

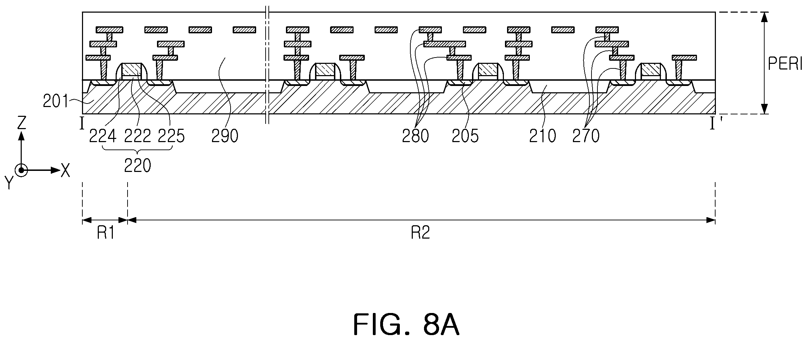

FIGS. 8A to 8M are cross-sectional views illustrating a method of manufacturing a semiconductor device according to an example embodiment. Each of FIGS. 8A to 8M illustrates a cross-sectional view corresponding to FIG. 2A.

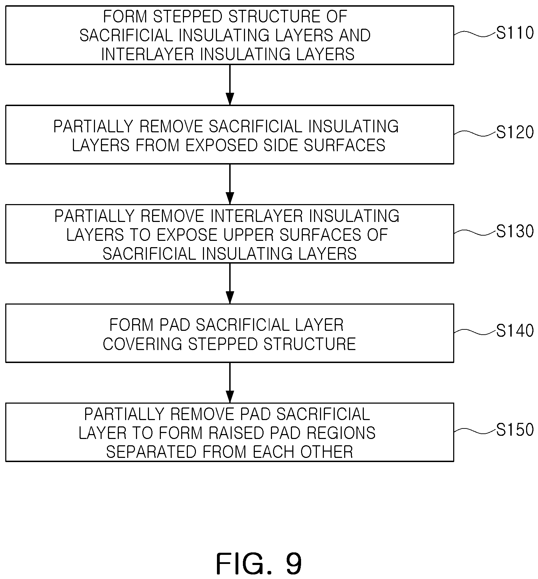

FIG. 9 is a flowchart illustrating a method of manufacturing a semiconductor device.

Referring to FIG. 8A, circuit devices 220, a circuit interconnection structure and a peripheral region insulating layer 290 forming a peripheral circuit region PERI may be formed on a substrate 201.

Device isolation layers 210 may be formed in the substrate 201, and a circuit gate dielectric layer 222 and a circuit gate electrode 225 may be formed in order on the substrate 201. The device isolation layers 210 may be formed by, for example, a shallow trench isolation (STI) process. The circuit gate dielectric layer 222 and the circuit gate electrode 225 may be formed using atomic layer deposition (ALD) and/or chemical vapor deposition (CVD). The circuit gate dielectric layer 222 may be formed of silicon oxide, and the circuit gate electrode 225 may be formed of at least one of polycrystalline silicon and/or a metal silicide layer, but example embodiments are not limited thereto. Next, a spacer layer 224 and impurity regions 205 may be formed on first and second sidewalls of the circuit gate dielectric layer 222 and the circuit gate electrode 225. In some example embodiments, the spacer layer 224 may include a plurality of layers. The impurity regions 205 may be formed by performing an ion implantation process such as a beamline and/or a plasma-assisted ion implantation process.

The circuit contact plugs 270 of the circuit interconnection structure may be formed by partially forming the peripheral region insulating layer 290, removing a portion thereof by etching, and filling the removed portion with the conductive material. The circuit interconnection lines 280 may be formed by, for example, depositing a conductive material and patterning the conductive material.

The peripheral region insulating layer 290 may include a plurality of insulating layers. A portion of the peripheral region insulating layer 290 may be formed in each of the processes of forming the circuit interconnection structure. In this way, the peripheral circuit region PERI including the circuit devices 220, the circuit interconnection structure, and the peripheral region insulating layer 290 may be formed.

Referring to FIGS. 8B and 9, on the peripheral circuit region PERI, a plate layer 101 provided with a memory cell region CELL, a horizontal insulating layer 110, a second horizontal conductive layer 104, and a substrate insulating layer 121 may be formed, sacrificial insulating layers 118 and interlayer insulating layers 120 may be alternately stacked to form a lower mold structure, and a stepped structure of the sacrificial insulating layers 118 and the interlayer insulating layers 120 may be formed (S 110).

The plate layer 101 may be formed on the peripheral region insulating layer 290. The plate layer 101 may be made of, for example, polycrystalline silicon, and may be formed through a CVD process. Polycrystalline silicon forming the plate layer 101 may include impurities such as at least one of boron, phosphorus, or arsenic.

The first and second horizontal insulating layers 111 and 112 included in the horizontal insulating layer 110 may be alternately stacked on the plate layer 101. The horizontal insulating layer 110 may be partially replaced with the first horizontal conductive layer 102 in FIG. 2B through a subsequent process. The first horizontal insulating layers 111 may include a material different from that of the second horizontal insulating layer 112. For example, the first horizontal insulating layers 111 may be formed of the same material as a material of the interlayer insulating layers 120, and the second horizontal insulating layer 112 may be formed of the same material as a material of the sacrificial insulating layers 118 subsequently formed. A portion of the horizontal insulating layer 110 may be removed from a portion of regions, for example, from the second region R2 by a patterning process.

The second horizontal conductive layer 104 may be formed on the horizontal insulating layer 110, and may be in contact with the plate layer 101 in a region from which the horizontal insulating layer 110 is removed.

The substrate insulating layer 121 may be formed to penetrate the plate layer 101 in some regions including a region in which contact plugs 170 (see FIG. 2A) will be disposed. The substrate insulating layer 121 may be formed by removing a portion of the plate layer 101, the horizontal insulating layer 110 and the second horizontal conductive layer 104, and then embedding the insulating material. After embedding the insulating material, a planarization process may be further performed using a chemical mechanical polishing (CMP) process and/or an etch-back process. As a result, an upper surface of the substrate insulating layer 121 may be substantially coplanar with an upper surface of the second horizontal conductive layer 104.

The lower mold structure may be formed on the second horizontal conductive layer 104 and the substrate insulating layer 121 at a height at which first channel structures CH1 (see FIG. 2A) of channel structures CH (see FIG. 2A) are disposed. The lower mold structure may be formed by alternately stacking the sacrificial insulating layers 118 and the interlayer insulating layers 120.

The sacrificial insulating layers 118 may be at least partially replaced with the gate electrodes 130 (see FIG. 2A) through a subsequent process. The sacrificial insulating layers 118 may be formed of a material different from a material of the interlayer insulating layers 120, and may be formed of a material which may be etched with etching selectivity with respect to the interlayer insulating layers 120 under specific etching conditions. For example, the interlayer insulating layer 120 and the upper interlayer insulating layer 125 may be formed of at least one of silicon oxide and silicon nitride, and the sacrificial insulating layers 118 may be formed of one or more materials selected from among silicon, silicon oxide, silicon carbide, and silicon nitride, but different from those of the interlayer insulating layer 120 and the upper interlayer insulating layer 125. In some example embodiments, the thicknesses of the interlayer insulating layers 120 may not be the same. Thicknesses of the interlayer insulating layers 120 and the sacrificial insulating layers 118, and/or a number of films thereof may vary from those illustrated.

The stepped structure may be formed by removing a portion of the sacrificial insulating layers 118 and the interlayer insulating layers 120, such that the sacrificial insulating layers 118 extend to different lengths. The stepped structure may be formed by repeatedly performing a process in which a mask layer is formed by performing a photolithography process and performing an etching process, and then removing a portion of the mask layer by a trimming process and performing an etching process.

The stepped structure may include unit step portions STa and STb, and the unit step portions STa and STb may include one or more sacrificial insulating layers 118. A portion of the interlayer insulating layer 120 may remain on an uppermost sacrificial insulating layer 118 in each of the unit step portion STa and STb. Side surfaces of the unit step portions STa and STb may be inclined with respect to an upper surface of the plate layer 101. In some embodiments, some of the unit step portions STa and STb may have different slopes.

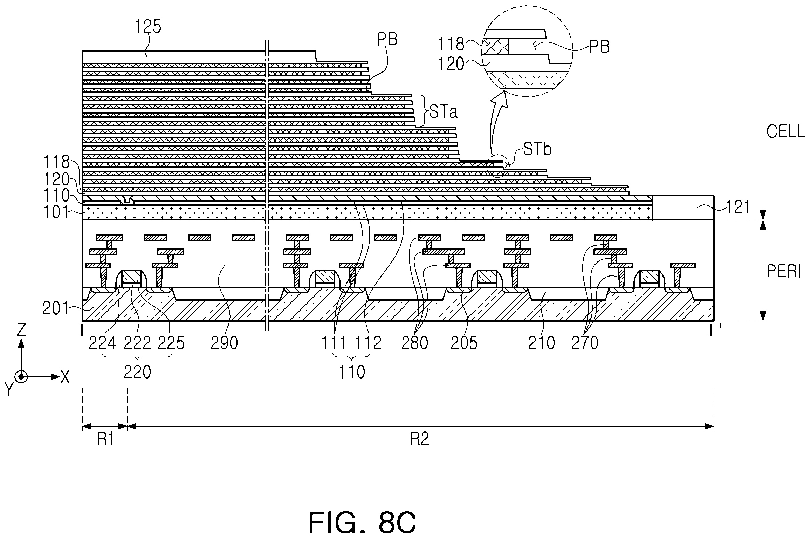

Referring to FIGS. 8C and 9, the sacrificial insulating layers 118 may be partially removed from exposed side surfaces thereof (S120).

The sacrificial insulating layers 118 may be partially removed from the side surfaces thereof exposed through the side surfaces of the unit step portions STa and STb to form removal regions PB. The sacrificial insulating layers 118 may be removed, for example, by a wet etching process using an etchant containing phosphoric acid. For example, a lateral depth of the removal regions PB may be equal to or greater than a thickness of the sacrificial insulating layers 118. In this process, the side surfaces of the sacrificial insulating layers 118 remaining after partial removal may be substantially perpendicular to the upper surface of the plate layer 101.

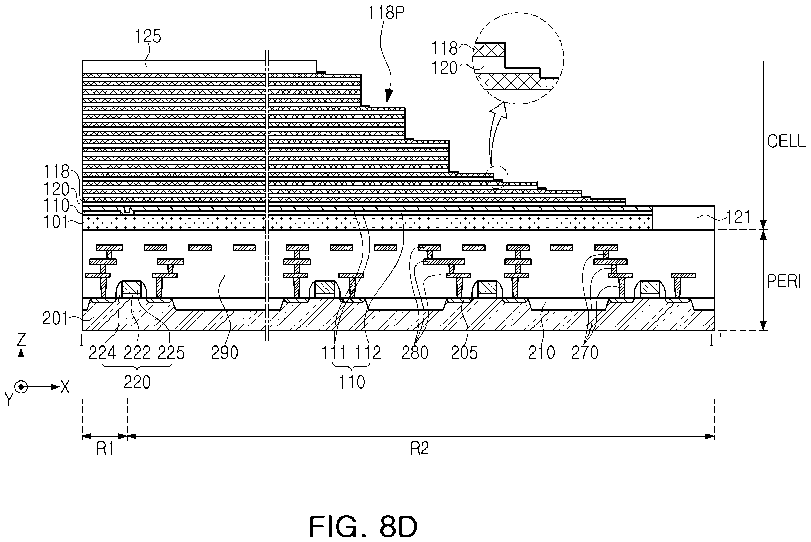

Referring to FIGS. 8D and 9, the interlayer insulating layers 120 may be partially removed to expose the upper surfaces of the sacrificial insulating layers 118 in the stepped structure (S130).

The interlayer insulating layers 120 may be partially removed from upper surfaces thereof exposed on the sacrificial insulating layers 118. As a result, the upper surfaces of the sacrificial insulating layers 118 may be exposed in the stepped structure. The interlayer insulating layers 120 may be removed selectively with respect to the sacrificial insulating layers 118, for example, using a wet etching process.

In this process, the relatively thick interlayer insulating layers 120 exposed through the removal regions PB may not be completely removed, and a portion thereof may remain. The sacrificial insulating layers 118 may also be partially removed from the exposed upper surfaces. The interlayer insulating layer 120 and the sacrificial insulating layer 118, the upper surfaces of which are exposed, may form respective preliminary pad regions 118P. In the preliminary pad region 118P, a step portion may be formed between the upper surface of the interlayer insulating layer 120 and the upper surface of the sacrificial insulating layer 118.

In the case of the embodiment of FIG. 4A, the structure may be formed in this process without the interlayer insulating layers 120 remaining in the preliminary pad region 118P. However, in this case, the sacrificial insulating layer 118 may be removed to a relatively greater thickness from the preliminary pad region 118P.

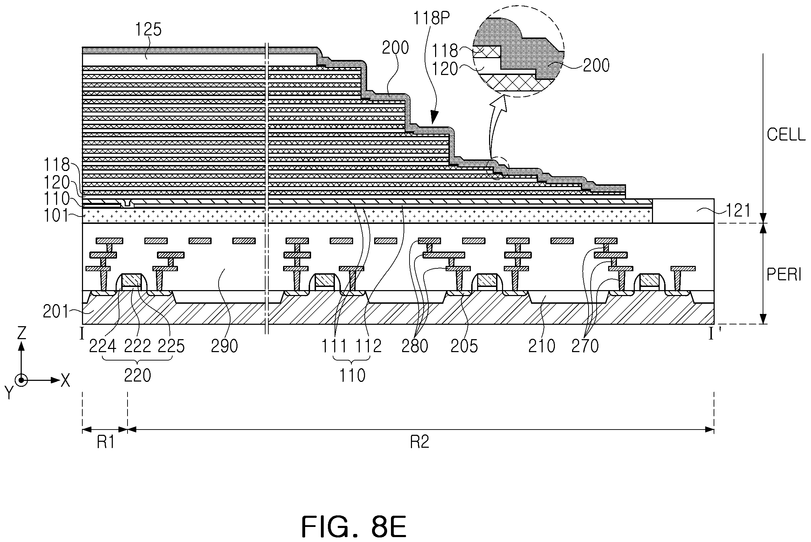

Referring to FIGS. 8E and 9, a pad sacrificial layer 200 covering the stepped structure may be formed (S140).

The pad sacrificial layer 200 may be formed to cover the entire stepped structure. The pad sacrificial layer 200 may include the same type of material as the sacrificial insulating layers 118, and may have a different etch rate from that of the sacrificial insulating layers 118. For example, the pad sacrificial layer 200 and the sacrificial insulating layers 118 may include silicon nitride but have different physical properties, whereby a degree of etching may be different under specific etching conditions.

The pad sacrificial layer 200 may be plasma treated in-situ after deposition. As a result, plasma treatment layers may be formed on a portion of a surface of the pad sacrificial layer 200. The plasma may reach in a straight line over the entire structure and, accordingly, the plasma treatment layers may be formed on horizontal surfaces in the pad sacrificial layer 200 and may not be formed on inclined or vertical surfaces. Since the side surfaces of the sacrificial insulating layer 118 were formed vertically through the process described above with reference to FIG. 8C, in this process, the plasma treatment layers may be separately formed between the preliminary pad regions 118P, without any regions being connected.

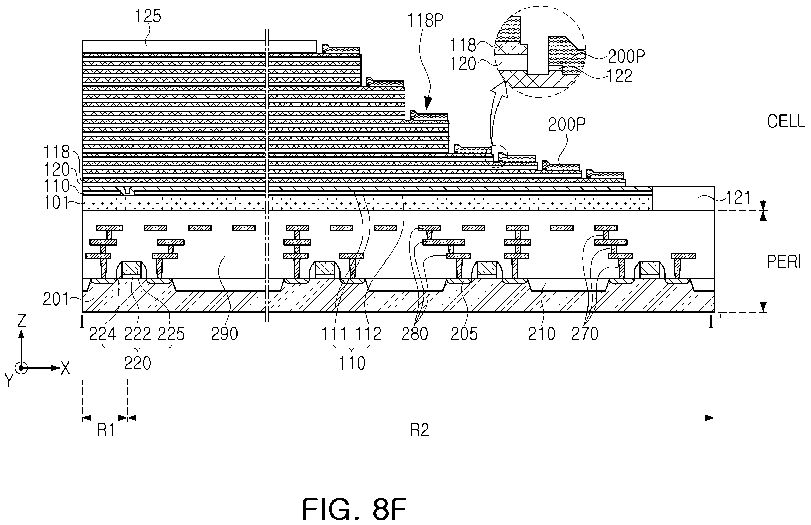

Referring to FIGS. 8F and 9, raised pad regions 200P separated from each other may be formed by partially removing the pad sacrificial layer 200 (S150).

The pad sacrificial layer 200 may be removed from inclined surface regions of the pad sacrificial layer 200 on which the plasma treatment layers are not formed, for example, by a wet etching process. As a result, the raised pad regions 200P separated from each other along the X-direction may be formed. In this process, after the pad sacrificial layer 200 is partially removed from the preliminary pad region 118P, the exposed interlayer insulating layer 120 may be partially removed, and the exposed sacrificial insulating layer 118 may also be lost to a predetermined thickness, whereby a level of the exposed upper surface of the sacrificial insulating layer 118 may be lowered. The interlayer insulating layer 120 remaining below the raised pad region 200P may form the pad insulating layer 122. The raised pad region 200P may be formed on the sacrificial insulating layer 118 and the pad insulating layer 122 in each preliminary pad region 118P.

As the plasma processing layers are separated from each other as described above with reference to FIG. 8E, the raised pad regions 200P formed in this process may also be formed to be more stably separated between adjacent preliminary pad regions 118P.

In the case of example embodiments illustrated and described with reference to FIG. 4B, a distance between the raised pad regions 200P is relatively large in this process, so that the structure may be formed without the pad insulating layer 122 remaining. In the case of the embodiment of FIG. 4C, the structure may be formed by changing a shape of the raised pad regions 200P according to the etching process conditions in this process.

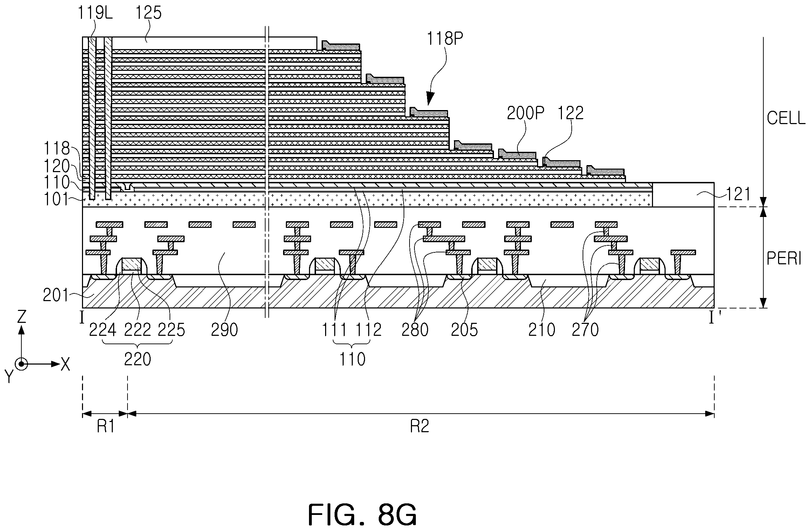

Referring to FIG. 8G, first channel sacrificial layers 119L penetrating the lower stack structure may be formed.

The first channel sacrificial layers 119L may be formed at positions corresponding to the first channel structures CH1 in the first region R1. The first channel sacrificial layers 119L may be formed by forming lower channel holes to penetrate the lower stack structure, then depositing a material forming the first channel sacrificial layers 119L in the lower channel holes, and performing a planarization process. The first channel sacrificial layers 119L may include, for example, polycrystalline silicon or carbon. In some embodiments, when forming the first channel sacrificial layers 119L, vertical sacrificial layers may also be formed in regions corresponding to lower regions of the contact plugs 170 of FIG. 2A.

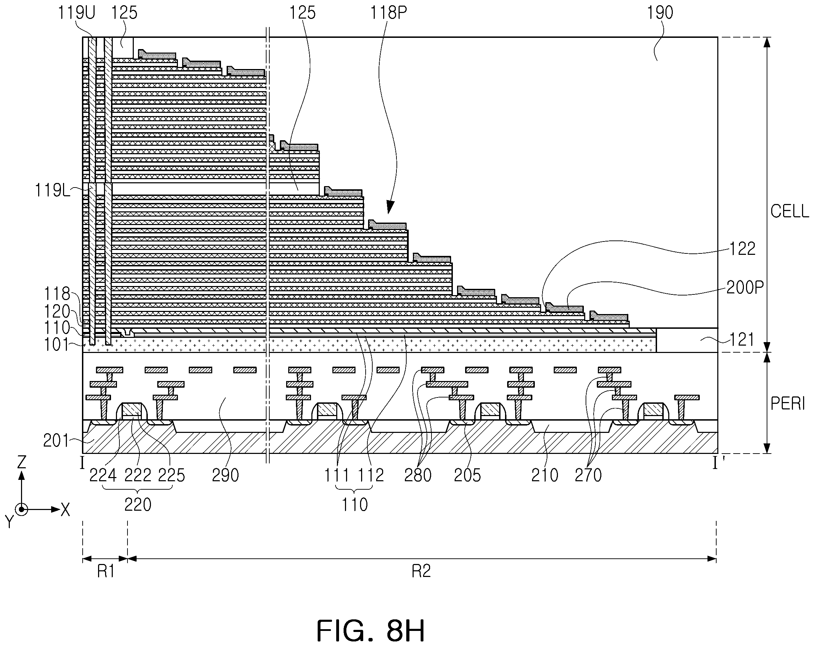

Referring to FIG. 8H, sacrificial insulating layers 118 and interlayer insulating layers 120 forming the upper mold structure are alternately stacked on the lower mold structure, and the raised pad regions 200P and the second channel sacrificial layers 119U may be formed.

In this process, the upper mold structure may be formed on the lower mold structure at a height at which the second channel structures CH2 (see FIG. 2A) of the channel structures CH (see FIG. 2A) are disposed. For the upper mold structure, the processes referring to FIGS. 8B to 8F may be performed in the same manner to form the raised pad regions 200P. In some embodiments, the process of forming the raised pad regions 200P may be performed simultaneously on the lower mold structure and the upper mold structure.

The second channel sacrificial layers 119U may be formed at positions corresponding to the second channel structures CH2 in the first region R1. The second channel sacrificial layers 119U may be formed to be respectively connected to the first channel sacrificial layers 119L. The second channel sacrificial layers 119U may be formed by depositing the same material as the first channel sacrificial layers 119L, for example, polycrystalline silicon and/or carbon. In some example embodiments, when forming the second channel sacrificial layers 119U, vertical sacrificial layers may also be formed in regions corresponding to upper regions of the contact plugs 170 of FIG. 2A.

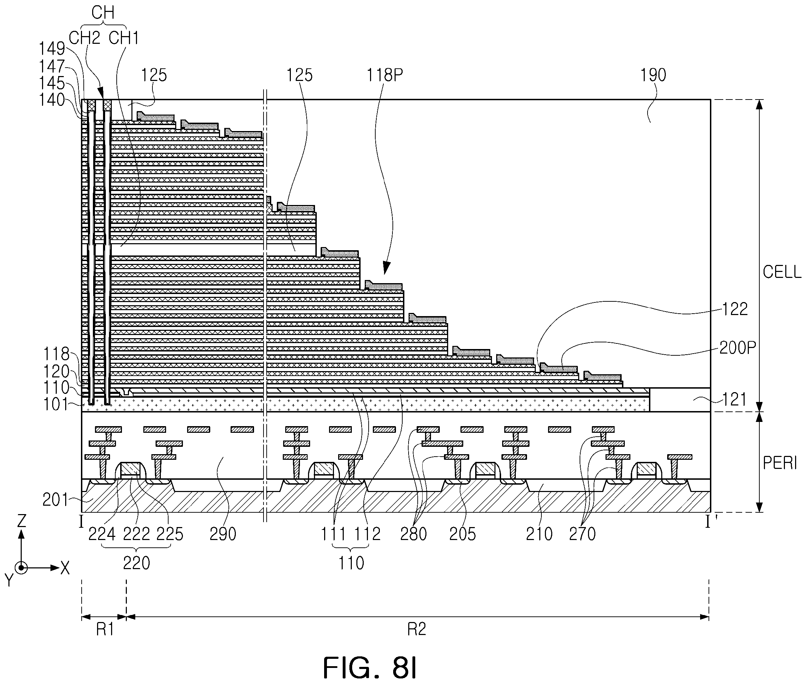

Referring to FIG. 8I, the channel structures CH penetrating the lower mold structure and the upper mold structure may be formed.

A cell region insulating layer 190 covering the lower mold structure and the upper mold structure may be formed.

The channel structures CH may be formed by removing the first and second channel sacrificial layers 119L and 119U in the first region R1 to form hole-shaped channel holes, and then sequentially depositing at least a portion of the gate dielectric layer 14, the channel layer 140, the channel filling insulating layer 147, and the channel pad 149 in the channel holes.

The gate dielectric layer 145 may be formed to have a uniform thickness using an ALD or CVD process. In this process, an entirety or a portion of the gate dielectric layer 145 may be formed, and a portion extending perpendicularly to the plate layer 101 along the channel structures CH may be formed in this process. The channel layer 140 may be formed on the gate dielectric layer 145 in the channel holes. The channel filling insulating layer 147 may be formed to fill the channel holes, and may be an insulating material. The channel pad 149 may be formed of a conductive material, such as polycrystalline silicon.

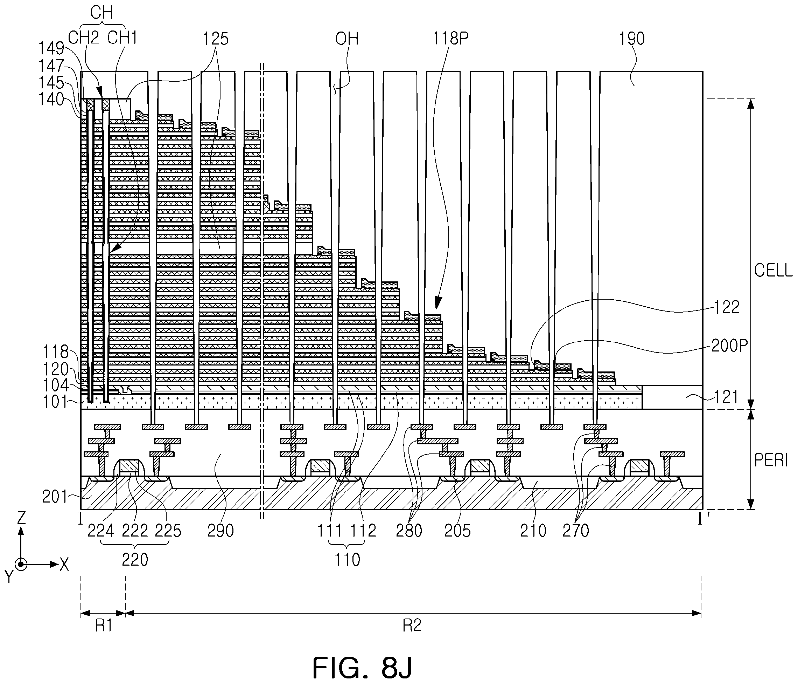

Referring to FIG. 8J, through-holes OH penetrating the lower mold structure and the upper mold structure may be formed.

The through-holes OH may be formed in regions corresponding to the contact plugs 170 of FIG. 2A in the second region R2. The through-holes OH may penetrate the cell region insulating layer 190, the upper interlayer insulating layers 125, the raised pad regions 200P, the sacrificial insulating layers 118, and the interlayer insulating layers 120, and may be formed to penetrate the substrate insulating layer 121 in a lower portion thereof. The circuit interconnection lines 280 may be exposed through bottom surfaces of the through-holes OH.

In some embodiments, when forming the first and second channel sacrificial layers 119L and 119U, if vertical sacrificial layers are also formed in regions corresponding to the contact plugs 170, the vertical sacrificial layers may be removed to form the through-holes OH.

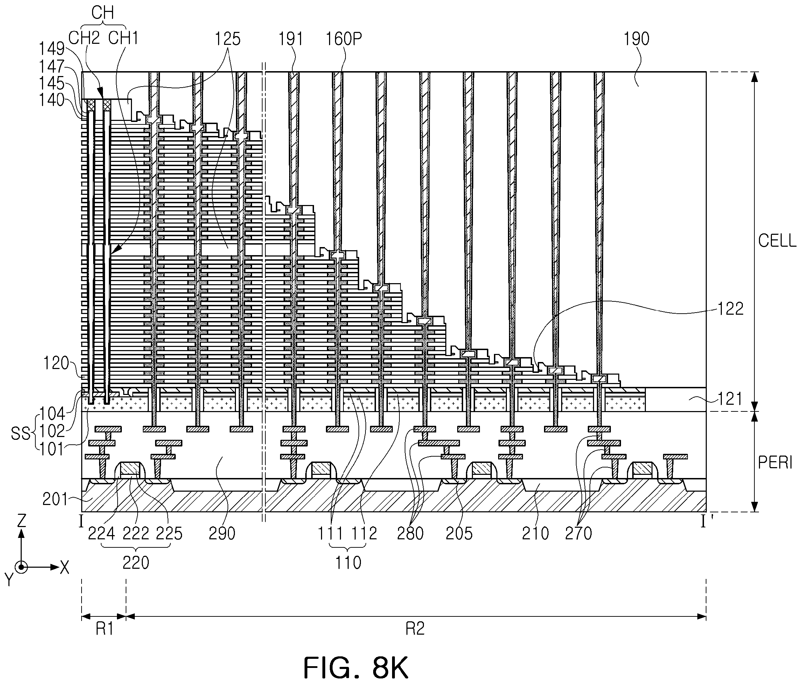

Referring to FIG. 8K, preliminary contact insulating layers 160P and vertical sacrificial layers 191 may be formed in the through-holes OH, a first horizontal conductive layer 102 may be formed, and the raised pad regions 200P and the sacrificial insulating layers 118 may be removed.

The raised pad regions 200P and the sacrificial insulating layers 118 exposed through the through-holes OH may be partially removed. Tunnel portions may be formed by removing the raised pad regions 200P and the sacrificial insulating layers 118 to a predetermined length around the through-holes OH. The tunnel portions may be formed to have a relatively short length in the preliminary pad regions 118P, and may be formed to have a relatively long length in the sacrificial insulating layers 118.

Specifically, initially, the tunnel portions may be formed to be relatively long in the preliminary pad regions 118P, as opposed to the mentioned above. This may be because the raised pad regions 200P include regions where an etching rate is relatively faster than the sacrificial insulating layers 118 therebelow. Next, a separate sacrificial layer may be formed in the through-holes OH and the tunnel portions. The sacrificial layer may be made of a material whose etch rate is less than that of the sacrificial insulating layers 118. Next, the sacrificial layer and the sacrificial insulating layers 118 may be partially removed. At this time, the sacrificial layer may remain in the preliminary pad regions 118P, and after the sacrificial layer is removed, the insulating layers 118 may be further partially removed in a lower portion thereof. As a result, the tunnel portions may be formed to have a relatively short length in the preliminary pad regions 118P.

An insulating material may be deposited in the through-holes OH and the tunnel portions to form the preliminary contact insulating layers 160P. The preliminary contact insulating layers 160P may be formed on sidewalls of the through-holes OH and fill the tunnel portions. In the preliminary pad regions 118P, the through-holes OH may not completely fill the tunnel portions.

The vertical sacrificial layers 191 may fill the through-holes OH and the tunnel portions of the preliminary pad regions 118P. The vertical sacrificial layers 191 may include a material different from the preliminary contact insulating layers 160P, for example, polycrystalline silicon such as doped polysilicon.

Openings penetrating the raised pad regions 200P, the sacrificial insulating layers 118, and the interlayer insulating layers 120 and extending to the plating layer 101 may be formed at positions of first and second separation regions MS1, MS2a, and MS2b (see FIG. 1). An etch-back process may be performed while forming separate sacrificial spacer layers in the openings to selectively remove the horizontal insulating layer 110 and remove a portion of the exposed gate dielectric layer 145 together, in the first region R1. After forming the first horizontal conductive layer 102 by depositing a conductive material in a region in which the horizontal insulating layer 110 is removed, the sacrificial spacer layers may be removed from within the openings. Through this process, the first horizontal conductive layer 102 may be formed in the first region R1.

The raised pad regions 200P and the sacrificial insulating layers 118 may be selectively removed with respect to the interlayer insulating layers 120, the second horizontal conductive layer 104, and the preliminary contact insulating layers 160P, for example, using a wet etching process.

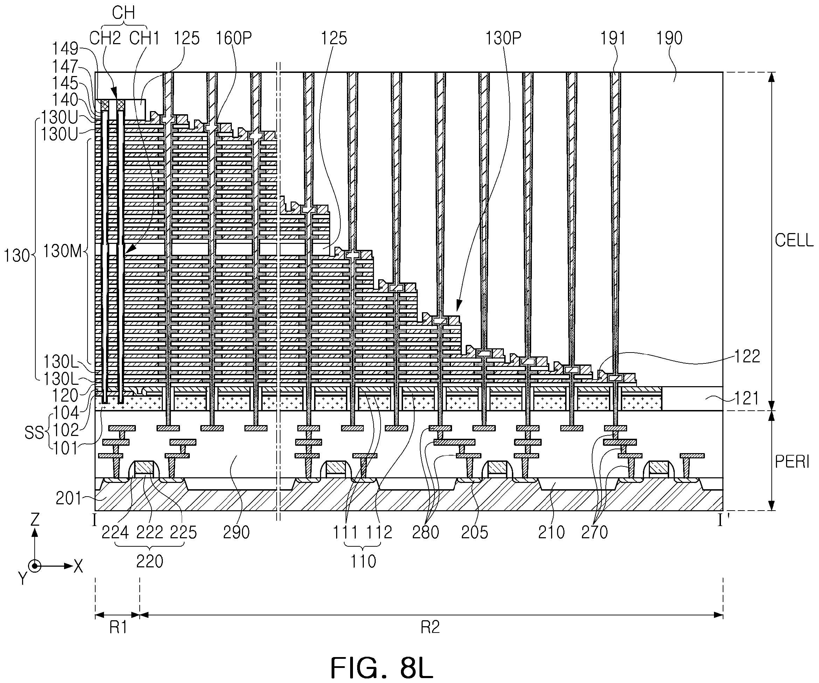

Referring to FIG. 8L, gate electrodes 130 may be formed.

The gate electrodes 130 may be formed by depositing a conductive material on regions in which the raised pad regions 200P and the sacrificial insulating layers 118 have been removed. The conductive material may include metal, polycrystalline silicon or metal silicide material. In some example embodiments, a portion of the gate dielectric layer 145 may be formed first before forming the gate electrodes 130. The gate electrodes 130 may have a shape according to the raised pad regions 200P and the sacrificial insulating layers 118, and the pad insulating layers 122 may be interposed therein, respectively. The lower region 130_1 and upper region 130_2 of the gate electrode 130 described above with reference to FIG. 3A are divided based on thickness for convenience of explanation, so the upper region 130_2 may be a region correspond to a portion of the upper portion of the raised pad region 200P. Accordingly, a lower surface of the above-described upper region 130_2 may not coincide with a lower surface of the raised pad region 200P.

After forming the gate electrodes 130, an insulating material may be deposited in the openings formed in the regions of the first and second isolation regions MS1, MS2a, and MS2b (see FIG. 1) to form the first and second isolation regions MS1, MS2a, and MS2b

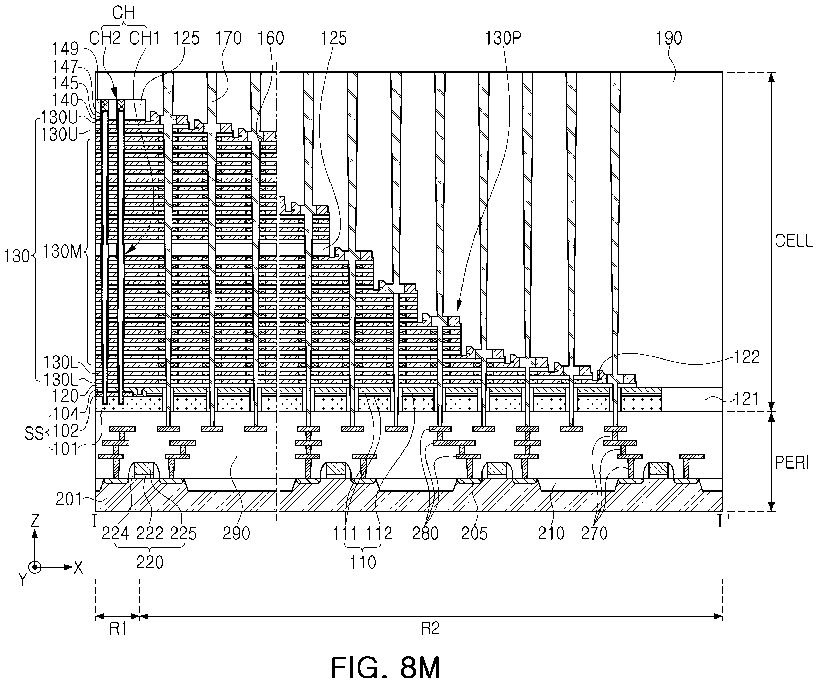

Referring to FIG. 8M, the vertical sacrificial layers 191 in the through-holes OH may be removed, and contact plugs 170 may be formed.

The vertical sacrificial layers 191 may be selectively removed with respect to the interlayer insulating layers 120 and the gate electrodes 130. After the vertical sacrificial layers 191 are removed, some of the exposed preliminary contact insulating layers 160P may also be removed. At this time, all of the preliminary contact insulating layers 160P may be removed in the pad regions 130P, and may remain therebelow to form contact insulating layers 160. In the pad regions 130P, when the gate dielectric layer 145 is exposed after the preliminary contact insulating layers 160P are removed, the gate dielectric layer 145 may also be removed to expose the side surfaces of the gate electrodes 130.

The contact plugs 170 may be formed by depositing a conductive material in the through-holes OH. The contact plugs 170 may be formed to have horizontal extensions 170H (see FIG. 3A) extending horizontally in the pad regions 130P, thereby being physically and electrically connected to the gate electrodes 130.

Next, referring to FIG. 2A together, studs 180 connected upper ends of the contact plugs 170 and the channel structures CH and cell interconnection lines 185 may be formed to manufacture the semiconductor device 100.

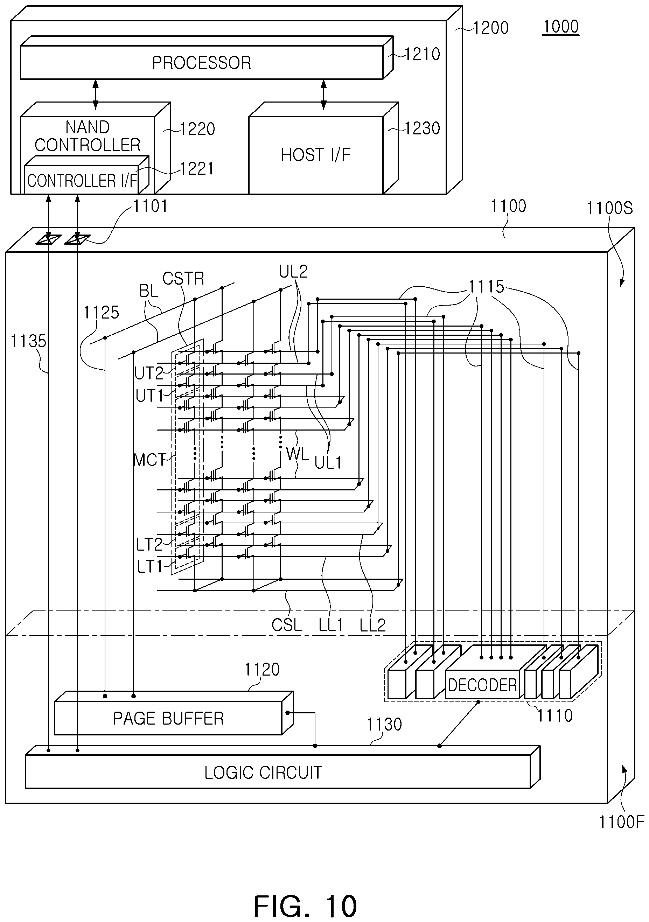

FIG. 10 is a view illustrating a data storage system including a semiconductor device according to an example embodiment.

Referring to FIG. 10, the data storage system 1000 may include a semiconductor device 1100 and a controller 1200 electrically connected to the semiconductor device 1100. The data storage system 1000 may be implemented as a storage device including one or more semiconductor devices 1100 or an electronic device including a storage device. For example, the data storage system 1000 may be implemented as a solid state drive device (SSD) including one or more semiconductor devices 1100, and one or more of a universal serial bus (USB), a computing system, a medical device or a communication device.

The semiconductor device 1100 may be implemented as a non-volatile memory device, such as the NAND flash memory device described in the aforementioned example embodiments with reference to FIGS. 1 to 7. The semiconductor device 1100 may include a first structure 1100F and a second structure 1100S on the first structure 1100F. In some example embodiments, the first structure 1100F may be disposed on a side of the second structure 1100S. The first structure 1100F may be implemented as a peripheral circuit structure including a decoder circuit 1110, a page buffer 1120 and a logic circuit 1130. The second structure 1100S may be implemented as a memory cell structure including a bit line BL, a common source line CSL, word lines WL, first and second gate upper lines UL1 and UL2, first and second gate lower lines LL1 and LL2 and memory cell strings CSTR disposed between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be varied in some example embodiments.

In some example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The word lines WL may be configured as gate electrodes of the memory cell transistors MCT, and the gate upper lines UL1 and UL2 may be configured as gate electrodes of the upper transistors UT1 and UT2, respectively.

In some example embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection interconnections 1115 extending from the first structure 1100F to the second structure 1100S. The bit lines BL may be electrically connected to the page buffer 1120 through second connection interconnections 1125 extending from the first structure 1100F to the second structure 1100S.

In the first structure 1100F, the decoder circuit 1110 and the page buffer 1120 may perform a control operation on at least one selected memory cell transistor of the plurality of memory cell transistors MCT. The decoder circuit 1110 and the page buffer 1120 may be controlled by the logic circuit 1130. The semiconductor device 1100 may communicate with the controller 1200 through the input/output pad 1101 electrically connected to the logic circuit 1130. The input/output pad 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In some example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, data to be read from the memory cell transistors MCT of the semiconductor device 1100 or the like may be transmitted. The host interface 1230 may provide a communication function between the data storage system 1000 and an external host. When a control command from an external host is received through the host interface 1230, the processor 1210 may control the semiconductor device 1100 in response to the control command.

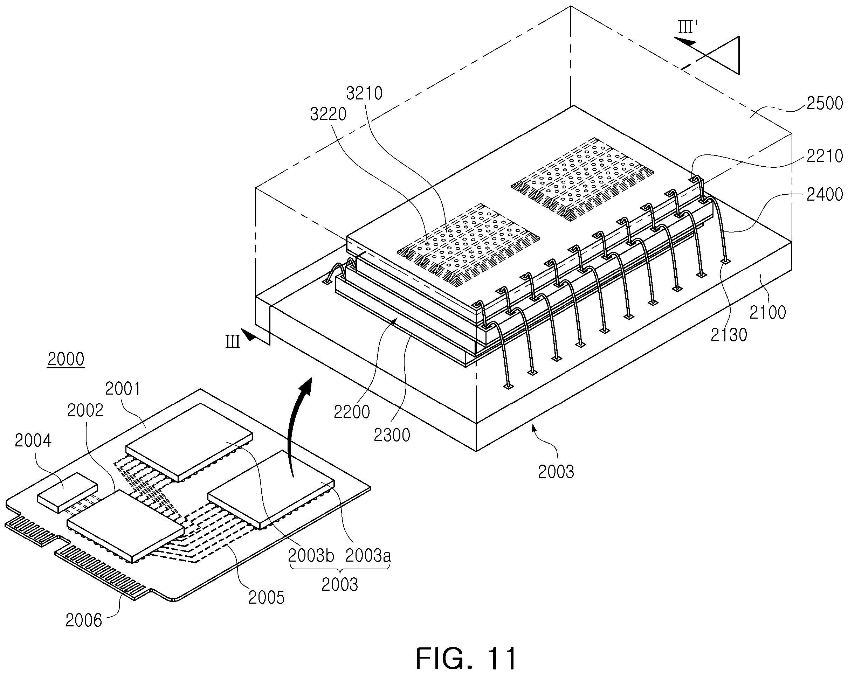

FIG. 11 is a perspective view illustrating a data storage system including a semiconductor device according to an example embodiment.

Referring to FIG. 11, a data storage system 2000 according to an example embodiment may include a main substrate 2001, a controller 2002 mounted on the main substrate 2001, one or more semiconductor packages 2003, and a DRAM 2004. The semiconductor package 2003 and the DRAM 2004 may be connected to the controller 2002 by interconnection patterns 2005 formed on the main substrate 2001.

The main substrate 2001 may include a connector 2006 including a plurality of pins coupled to an external host. The number and arrangement of the plurality of pins in the connector 2006 may vary depending on a communication interface between the data storage system 2000 and the external host. In some example embodiments, the data storage system 2000 may communicate with the external host according to any one or more of interfaces such as universal serial bus (USB), peripheral component interconnect express (PCI-Express), serial advanced technology attachment (SATA), M-Phy for universal flash storage (UFS), and the like. In some example embodiments, the data storage system 2000 may operate by power supplied from the external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and the external host. The DRAM 2004 included in the data storage system 2000 may operate as a cache memory, and may provide a space for temporarily storing data in a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 10. Each of the semiconductor chips 2200 may include gate stack structures 3210 and channel structures 3220. Each of the semiconductor chips 2200 may include the semiconductor device described in the aforementioned example embodiments with reference to FIGS. 1 to 7.

In some example embodiments, the connection structure 2400 may be configured as a bonding wire electrically connecting the input/output pad 2210 to the upper package pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In some example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In some example embodiments, the controller 2002 and the semiconductor chips 2200 may be included in a single package. In an example embodiment, the controller 2002 and the semiconductor chips 2200 may be mounted on a separate interposer substrate different from the main substrate 2001, and the controller 2002 and the semiconductor chips 2200 may be connected to each other by an interconnection formed on the interposer substrate.

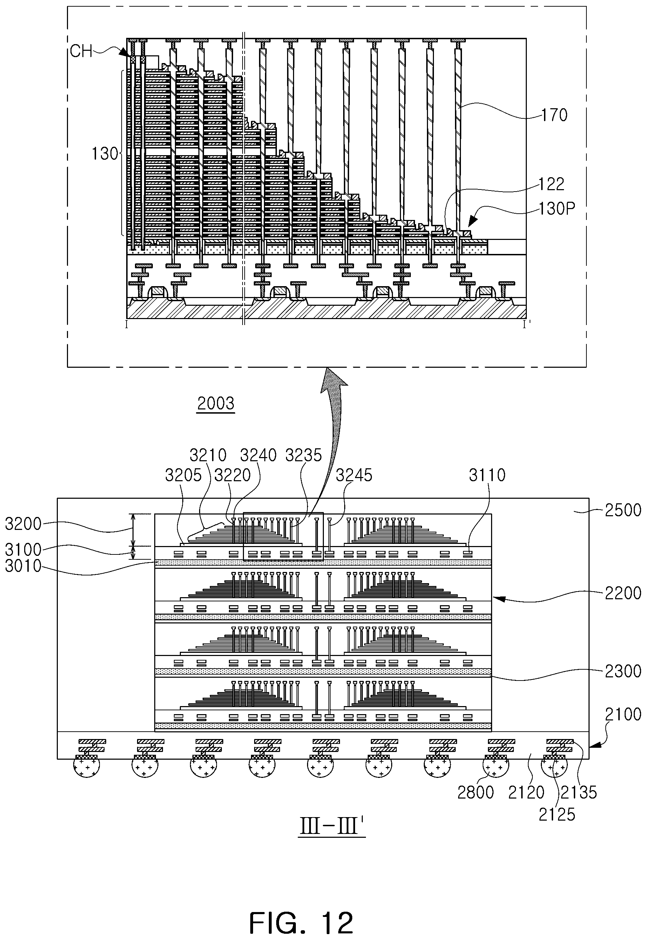

FIG. 12 is a cross-sectional view illustrating a semiconductor package according to an example embodiment, illustrating an example embodiment of the semiconductor package 2003 in FIG. 11 taken along line III-III' in FIG. 12.

Referring to FIG. 12, in the semiconductor package 2003, the package substrate 2100 may be implemented as a printed circuit board. The package substrate 2100 may include a package substrate body 2120, package upper pads 2130 (see FIG. 11) disposed on the upper surface of the package substrate body 2120, lower pads 2125 disposed on the lower surface of the package substrate body 2120 or exposed through the lower surface, and internal interconnections 2135 electrically connecting the upper pads 2130 to the lower pads 2125 in the package substrate body 2120. The lower pads 2125 may be connected to the interconnection patterns 2005 of the main substrate 2010 of the data storage system 2000 as illustrated in FIG. 11 through conductive connection portions 2800.

Each of the semiconductor chips 2200 may include a semiconductor substrate 3010, and a first structure 3100 and a second structure 3200 stacked in sequence on the semiconductor substrate 3010. The first structure 3100 may include a peripheral circuit region including peripheral interconnections 3110. The second structure 3200 may include a common source line 3205, a gate stack structure 3210 on the common source line 3205, channel structures 3220 penetrating the gate stack structure 3210, bit lines 3240 electrically connected to the memory channel structures 3220, and contact plugs 3235 electrically connected to the word lines WL (see FIG. 10) of the gate stack structure 3210. As described in the aforementioned example embodiments with reference to FIGS. 1 to 7, in each of the semiconductor chips 2200, the pad insulating layer 122 may be interposed within the gate electrodes 130 in the pad regions 130P, and the upper surface thereof may have a stepped structure with a lower level.

Each of the semiconductor chips 2200 may include a through interconnection 3245 electrically connected to the peripheral interconnections 3110 of the first structure 3100 and extending into the second structure 3200. The through interconnection 3245 may be disposed outside the gate stack structure 3210, and may be further disposed to penetrate the gate stack structure 3210. Each of the semiconductor chips 2200 may further include an input/output pad 2210 (see FIG. 11) electrically connected to the peripheral interconnections 3110 of the first structure 3100.

Gate electrodes may include pad regions connected to contact plugs, and by optimizing the manufacturing method and structure of these pad regions, a semiconductor device with improved reliability and a data storage system including the same may be provided.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Moreover, when the words "generally" and "substantially" are used in connection with material composition, it is intended that exactitude of the material is not required but that latitude for the material is within the scope of the disclosure.

Further, regardless of whether numerical values or shapes are modified as "about" or "substantially," it will be understood that these values and shapes should be construed as including a manufacturing or operational tolerance (e.g., ±10%) around the stated numerical values or shapes. Thus, while the term "same," "identical," or "equal" is used in description of example embodiments, it should be understood that some imprecisions may exist. Thus, when one element or one numerical value is referred to as being the same as another element or equal to another numerical value, it should be understood that an element or a numerical value is the same as another element or another numerical value within a desired manufacturing or operational tolerance range (e.g., ±10%).

While various example embodiments have been shown and described above, it will be apparent to those skilled in the art that modifications and variations could be made without departing from the scope of inventive concepts as defined by the appended claims. Furthermore, example embodiments are not necessarily mutually exclusive. For example, some example embodiments may include one or more features described with reference to one or more figures, and may also include one or more other features described with reference to one or more other figures.

## Claims

1. A semiconductor device, comprising:
a first semiconductor structure (PERI; S1; 3100) comprising a substrate (201; 3010), circuit elements (220) on the substrate (201), and circuit interconnection lines (280) on the circuit elements (220); and
a second semiconductor structure (CELL; S2; 3200) on the first semiconductor structure (PERI; S1; 3100) and having a first region (R1) and a second region (R2);
wherein the second semiconductor structure (CELL; S2; 3200) includes,
a plate layer (101),
gate electrodes (130) on the plate layer (101), spaced apart from each other in a first direction (Z), perpendicular to an upper surface of the plate layer (101), extending by different lengths in a second direction (X) perpendicular to the first direction (Z), and respectively comprising a lower region (130_1) extending from the first region (R1) and an upper region (130_2) in the second region (R2) and on the lower region (130_1),
interlayer insulating layers (120) alternately stacked with the gate electrodes (130),
channel structures (CH) penetrating at least a portion of the gate electrodes (130) in the first region (R1) and extending in the first direction (Z),
contact plugs (170) respectively connected to the gate electrodes (130) in the second region (R2) and extending in the first direction (Z), and
a pad insulating layer (122) interposed between the lower region (130_1) and the upper region (130_2) of each of the gate electrodes (130) and spaced apart from the interlayer insulating layers (120).

2. The semiconductor device of claim 1, wherein an upper surface of the upper region (130_2) comprises a bent region.

3. The semiconductor device of claim 1 or 2, wherein an upper surface of a first end region of the upper region (130_2) adjacent to the first region (R1) is on a first level, and an upper surface of a second end region of the upper region (130_2) opposing the first end region in the second direction (X) is on a second level lower than the first level.

4. The semiconductor device of claim 3, wherein a difference between the first level and the second level ranges from 3 nm to 7 nm.

5. The semiconductor device of any one of claims 1 to 4, wherein the upper region (130_2) is spaced inwardly from a side surface of the lower region (130_1) in the second direction (X) toward the first region (R1) and is on the lower region (130_1).

6. The semiconductor device of any one of claims 1 to 5, wherein the lower region (130_1) has a first thickness (T1) in a region where an upper surface of the lower region (130_1) is covered by an interlayer insulating layer (120) of the interlayer insulating layers, and a second thickness (T2) in a region between a side surface of the interlayer insulating layer (120) and the upper region (130_2), the second thickness (T2) being less than the first thickness (T1).

7. The semiconductor device of any one of claims 1 to 6, wherein
the gate electrodes (130) comprise a first gate electrode and a second gate electrode on the first gate electrode, and
a third level of an uppermost surface of the upper region (130_2) of the first gate electrode is higher than a fourth level of a lower surface of the second gate electrode.

8. The semiconductor device of claim 7, wherein the third level is a level between an upper surface and the lower surface of the second gate electrode.

9. The semiconductor device of any one of claims 1 to 8, wherein each of the gate electrodes (130) has a maximum thickness (T4) at an inner end region adjacent to the first region of the upper region (130_2) and a minimum thickness (T3) at an outer end region of the lower region (130_1) furthest from the first region.

10. The semiconductor device of any one of claims 1 to 9, wherein at least a side surface of the pad insulating layer (122) in the second direction (X) is exposed from each of the gate electrodes (130).

11. The semiconductor device of claim 10, wherein the side surface of the pad insulating layer (122) is coplanar with a side surface (130_2S1) of the upper region (130_2).

12. The semiconductor device of any one of claims 1 to 11, wherein the pad insulating layer (122) has a thickness less than a thickness of each of the interlayer insulating layers (120).

13. The semiconductor device of any of claims 1 to 12, wherein each of the contact plugs (170) comprises a vertical extension extending in the first direction (Z) and a horizontal extension extending horizontally from the vertical extension and contacting the upper region (130_2) and the lower region (130_1) of one of the gate electrodes (130).

14. A data storage system, comprising:
the semiconductor device (2200) of any one of the preceding claims, the semiconductor device (2200) further including an input/output pad (2210) electrically connected to the circuit elements (220); and
a controller (2002) electrically connected to the semiconductor device (2200) through the input/output pad (2210) and configured to control the semiconductor device (2200).

15. The data storage system of claim 14, wherein each of the gate electrodes (130) covers an upper surface, a lower surface, and a side surface of the pad insulating layer (122).
